(19) Europäisches Patentamt
European Patent Office
Office européen des brevets

(11) **EP 3 874 343 B1**

(12) **EUROPÄISCHE PATENTSCHRIFT**

(45) Veröffentlichungstag und Bekanntmachung des Hinweises auf die Patenterteilung:
**04.10.2023 Patentblatt 2023/40**

(21) Anmeldenummer: **19798251.5**

(22) Anmeldetag: **01.11.2019**

(51) Internationale Patentklassifikation (IPC):
**G05F 7/00** (2006.01)    **G01R 33/032** (2006.01)

(52) Gemeinsame Patentklassifikation (CPC):
**G05F 7/00; G01R 33/032**

(86) Internationale Anmeldenummer:
**PCT/EP2019/079992**

(87) Internationale Veröffentlichungsnummer:
**WO 2020/089465 (07.05.2020 Gazette 2020/19)**

(54) **VORRICHTUNG UND VERFAHREN ZUR ERZEUGUNG UND REGELUNG EINER MAGNETISCHEN FELDSTÄRKE**

DEVICE AND METHOD FOR GENERATING AND CONTROLLING A MAGNETIC FIELD STRENGTH

DISPOSITIF ET PROCÉDÉ POUR GÉNÉRER ET RÉGULER UNE INTENSITÉ DE CHAMP MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.11.2018 DE 102018127394**

(43) Veröffentlichungstag der Anmeldung:
**08.09.2021 Patentblatt 2021/36**

(73) Patentinhaber: **Quantum Technologies GmbH**
**04103 Leipzig (DE)**

(72) Erfinder:
- **MEIJER, Jan Berend**
  **04109 Leipzig (DE)**
- **STAACKE, Robert**
  **04109 Leipzig (DE)**
- **NEUHÄUSER, Florian**
  **04109 Leipzig (DE)**
- **JOHN, Roger**
  **04109 Leipzig (DE)**
- **BÄHR, Mario**
  **99310 Osthausen (DE)**
- **BURCHARD, Bernd**
  **45276 Essen (DE)**

(74) Vertreter: **Hecht, Jan-David**
**Patentanwaltskanzlei Dr. Hecht**
**Ranstädter Steinweg 28**
**04109 Leipzig (DE)**

(56) Entgegenhaltungen:
**WO-A1-2018/174912     WO-A2-2017/189113**
**DE-A1- 2 318 335      DE-B2- 2 318 335**
**US-A1- 2016 116 553**

- **RUSSELL J JIRBERG: "Automatic Distortionless Control of Magnetic Field Modulation", REVIEW OF SCIENTIFIC INSTRUMENTS,, Bd. 40, Nr. 1, 1. Januar 1969 (1969-01-01) , Seiten 173-174, XP001407456,**
- **LINBO SHAO ET AL: "Wide-Field Optical Microscopy of Microwave Fields Using Nitrogen-Vacancy Centers in Diamonds", ADVANCED OPTICAL MATERIALS, Bd. 4, Nr. 7, 1. Juli 2016 (2016-07-01), Seiten 1075-1080, XP055450437, DE ISSN: 2195-1071, DOI: 10.1002/adom.201600039**
- **SHAO LINBO ET AL: "Diamond color center based FM microwave demodulator", 2016 CONFERENCE ON LASERS AND ELECTRO-OPTICS (CLEO), OSA, 5. Juni 2016 (2016-06-05), Seiten 1-2, XP033025062, [gefunden am 2016-12-16]**

**Beschreibung**

Die vorliegende Erfindung betrifft eine Vorrichtung zur Erzeugung und Regelung einer magnetischen Feldstärke nach dem Oberbegriff von Anspruch 1 und ein Verfahren zur Erzeugung und Regelung einer magnetischen Feldstärke nach dem Oberbegriff von Anspruch 18.

Magnetfelder und damit einhergehend bestimmte magnetische Feldstärken werden üblicherweise mittels Spulenanordnungen erzeugt. Problematisch daran ist, dass dabei keine externen Magnetfelder berücksichtigt werden können. Diese können nur über eine magnetische Schirmung ausgeschaltet werden.

Eine ebenso schwierige Aufgabe ist es, Referenzwerte physikalischer Größen zu erzeugen. Solche Referenzwerte haben in Wissenschaft und Technik eine sehr große Bedeutung. In Bezug auf die Zeit ist dies sofort ersichtlich, aber auch für andere physikalische Größen, wie die Stromstärke, die Spannung, da magnetische Feld, das elektrische Feld und dgl. sind Referenzwerte vor allem auch als Bezugswerte sehr wichtig.

Der Referenzwert für die Zeit ist die Sekunde, die definiert ist als 9 192 631 770-fache der Periodendauer der dem Übergang zwischen den beiden Hyperfeinstrukturniveaus des Grundzustandes von Atomen des Caesium-Isotops $^{133}$Cs entsprechenden Strahlung. Referenzwertgeber zur Vorgabe der Dauer einer Sekunde sind durch sogenannte Atomuhren bekannt.

Für die Länge kann ein Referenzwert für den Meter aus der Definition abgeleitet werden, dass ein Meter der Länge der Strecke entspricht, die das Licht im Vakuum während der Dauer von 1 / 299 792 458 Sekunde zurücklegt. Dieser Referenzwert wird also auf den Referenzwert für die Zeit zurückgeführt.

Die Stromstärke ist darüber definiert, dass 1 A die Stärke des zeitlich konstanten elektrischen Stromes ist, der im Vakuum zwischen zwei parallelen, unendlich langen, geraden Leitern mit vernachlässigbar kleinem, kreisförmigem Querschnitt und dem Abstand von 1 m zwischen diesen Leitern eine Kraft von $2 \cdot 10^{-7}$ Newton pro Meter Leiterlänge hervorrufen würde. Hieraus lässt sich keine direkte Lösung für die Bereitstellung eines Referenzwertes für die Stromstärke finden, die kostengünstig und zugleich praktikabel ist. Dies gilt beispielsweise auch für die Spannung, das magnetische Feld und das elektrische Feld. Schließlich ist die Vermessung magnetischer Flussdichten eine Grundfunktion der Sensorik, wobei es das Ziel ist, die Auflösung und die Robustheit entsprechender Sensoren weiter zu verbessern.

Aus der DE 10 2015 208 151 A1 und der DE 10 2017 205 099 A1 sind Verfahren bekannt, bei dem die Fluoreszenzintensität eines Diamantmaterials mit einem Stickstofffehlstellenzentrum ausgewertet wird, um auf das magnetische Feld, welches auf das Stockstofffehlstellenzentrum einwirkt, und den dieses magnetische Feld verursachenden elektrischen Strom eines Leiter rückschließen zu können. Dabei werden zwei unterschiedliche Anregu n-gen, nämlich eine optische und eine Mikrowellenanregung des Stickstofffehlstellenzentrums eingesetzt, was die entsprechende Vorrichtung teuer und komplex macht. Ein weiteres relevantes Dokument ist WO2018/174912.

Aus A. Wickenbrock et al., "Microwave-free magnetometry with nitrogen-vacancy centers in diamond", Appl. Phys. Lett. 109, 053505 (2016), ist die Vermessung von Magnetfeldern ohne die Verwendung von Mikrowellen bekannt. Dabei besteht allerdings das Problem, dass die Flussdichte präzise eingestellt werden muss.

Im Rahmen der vorliegenden Erfindung wird beim Magnetfeld zwischen magnetischer Feldstärke (magnetische Erregung) und magnetischer Flussdichte unterschieden. Genaugenommen ist die magnetische Flussdichte B abhängig von der magnetischen Erregung H entsprechend dem Zusammenhang $B = \mu_0 \, \mu_r \, H$, wobei $\mu_0$ die magnetische Feldkonstante ist und $\mu_r$ die Permeabilitätszahl. Gemessen wird dabei die magnetische Flussdichte, während beim Stromfluss durch einen Leiter, insbesondere eine Spule, ein magnetisches Feld mit einer bestimmten Feldstärke erzeugt wird.

Es ist daher Aufgabe der vorliegenden Erfindung, eine Vorrichtung und ein Verfahren bereitzustellen, mit denen eine magnetische Feldstärke erzeugbar und regelbar ist. Bevorzugt sollen damit ein oder mehrere der vorgenannten Nachteile beseitigt werden. Vorzugsweise soll damit ein Referenzwert einer physikalischen Größe relativ einfach und kostengünstig erzeugbar sein. Insbesondere soll die Vorrichtung auch sehr klein und mobil verwendbar sein. Weiterhin wäre es vorteilhaft, wenn mit der Vorrichtung auch magnetische Flussdichten mit hoher Auflösung und insbesondere sehr robust vermessen werden können.

Diese Aufgabe wird gelöst mit der erfindungsgemäßen Vorrichtung nach Anspruch 1 und dem erfindungsgemäßen Verfahren nach Anspruch 18. Vorteilhafte Weiterbildungen sind in den Unteransprüchen und in der nachfolgenden Beschreibung zusammen mit den Figuren angegeben.

Erfinderseits wurde erkannt, dass diese Aufgabe in überraschender Art und Weise dadurch besonders einfach dadurch gelöst werden kann, dass die magnetische Feldstärke auf einen in einem Material von ihr abhängigen Resonanzextremwert in der Lumineszenz, bzw. im Photostrom zurückgeführt wird. Da diese Abhängigkeit sehr gut bekannt und auch sehr stabil ist, können entsprechende magnetische Feldstärken sehr zuverlässig und reproduzierbar geregelt werden. Genauer gesagt hängt die magnetische Feldstärke im Wesentl i-chen von der den Resonanzextremwert auslösenden magnetischen Flussdichte B am Ort des Lumineszenz- bzw. des Photostromzentrums und damit vorteilhafterweise ausschließlich von Naturkonstanten ab, die keiner Kalibration bedürfen. Die Resonanzstelle stellt beispielsweise eine Polstelle des invertierten Lumineszenzwertes in Abhängigkeit von der magnetischen Flussdichte B dar. Aufgrund dieser bezogen auf den Parameter der magnetischen Flussdichte B punktförmigen Resonanzstelle führen kleinste Abweichungen des magnetischen Flusses B zu einer sehr hohen Signalempfindlichkeit, so dass die magnetische Feldstärke unabhängig von sonstigen Einflüssen sehr genau erzeugbar ist. Aus der Literatur (vgl. beispielsweise J. Lepper, "Der Zusammenhang von Elektronenemission und Lumineszenzerscheinungen angeregter Kristalle", Z. Naturforschg. 10a, 47-52 (1955), ist bekannt, dass ein enger Zusammenhang zwischen der Lumineszenz und dem Photostrom besteht.

Die erfindungsgemäße Vorrichtung zur Erzeugung und Regelung einer magnetischen Feldstärke ist gekennzeichnet durch:

- ein erstes Material, das bei einer physikalischen Anregung eine Lumineszenz und/oder einen Photostrom erzeugt, wobei die Luminszenz bzw. der Photostrom in Bezug auf ein magnetisches Feld bei zumindest einer magnetischen Flussdichte einen Extremwert (in Form einer Resonanz) aufweist,
- Mittel zur Erzeugung der physikalischen Anregung,
- Mittel zur Magnetfelderzeugung, wobei das erste Material dem erzeugten Magnetfeld ausgesetzt ist, wobei die magnetische Feldstärke einstellbar ist,
- Mittel zur Messung der Lumineszenz bzw. des Photostroms mit einem Erfassungssignal, das die Stärke des erfassten Lumineszenzsignals bzw. Photostromsignals wiedergibt,
- Mittel zur Regelung, die angepasst sind, ein Regelsignal für die Regelung der Mittel zur Magnetfelderzeugung auszugeben und die magnetische Feldstärke in Abhängigkeit vom Erfassungssignal so zu regeln, dass das Erfassungssignal einen Extremwert annimmt.

"Mittel zur Erzeugung der physikalischen Anregung" sind jegliche Mittel, mit denen die physikalische Anregung erzeugbar ist. Dabei kommt es nicht darauf an, dass die Größe der physikalischen Anregung tatsächlich veränderbar ist. Es reicht, wenn die physikalische Anregung so erzeugbar ist, dass die Resonanz in der Lumineszenz bzw. dem Photostrom auftritt. In einer bevorzugten Weiterbildung ist die Größe der Anregung, beispielsweise deren Frequenz, durch die Mittel zur Erzeugung der physikalischen Anregung zumindest über einen bestimmten Bereich diskret oder kontinuierlich durchstimmbar.

Zur Feststellung des Extremwertes können vorzugsweise Mittel zur Erfassung der ersten und/oder der zweiten Ableitung des Erfassungssignals in Abhängigkeit von der magnetischen Flussdichte bestehen. Während über Nullstellen in der ersten Ableitung Maxima bzw. Minima in dem Erfassungssignal bestimmt werden können, kann über Nullstellen in der zweiten Ableitung auf Extremwerte in der ersten Ableitung geregelt werden. Die zweite Variante ist sehr vorteilhaft, weil dann mit höchster Empfindlichkeit geregelt werden kann. "Extremwert im Erfassungssignal" meint somit nicht nur ein Maximum bzw. Minimum im Erfassungssignal, sondern auch ein Maximum oder Minimum in der ersten Ableitung des Erfassungssignals, "Extremwert im Erfassungssignal" ist somit vorzugsweise zu lesen als "Extremwert im Erfassungssignal oder in der ersten Ableitung des Erfassungssignals".

In einer vorteilhaften Weiterbildung ist vorgesehen, dass Mittel zur Erzeugung einer physikalischen Größe in Abhängigkeit vom Regelsignal bestehen. Dadurch können Referenzwerte sehr genau und reproduzierbar hergestellt werden. Es wird dabei strikt unterschieden zwischen "physikalische Größe", die sich auf den Referenzwert bezieht, und "physikalische Anregung", die sich auf eine bestimmte physikalische Größe bezieht, mit der die Lumineszenz bzw. der Photostrom im Material erzeugt wird.

In einer vorteilhaften Weiterbildung ist vorgesehen, dass die physikalische Größe eine Größe aus der Gruppe umfassend elektrischer Strom, elektrische Spannung, magnetisches Feld (magnetische Flussdichte B oder magnetische Feldstärke H), elektrisches Feld, Zeit und Frequenz ist. Solche Referenzwerte werden besonders oft und für verschiedene Anwe n-dungsfelder benötigt.

In einer vorteilhaften Weiterbildung ist vorgesehen, dass die Mittel zur Erzeugung der physikalischen Größe zumindest ein Element aus der Gruppe: Stromspiegel, Quellenwiderstand, Spule, Kondensator, Transkonduktanzverstärker und Operationsverstärker umfassen. Dann lassen sich Referenzwerte für den elektrischen Strom, die elektrische Spannung, das magnetische Feld, das elektrische Feld, die Zeit und eine Frequenz erzeugen.

In einer vorteilhaften Weiterbildung ist vorgesehen, dass weiterhin bestehen:

- ein weiteres Material, das bei einer weiteren physikalischen Anregung eine Lumineszenz und/oder einen Photostrom erzeugt, wobei die Luminszenz bzw. der Photostrom in Bezug auf ein magnetisches Feld bei zumindest einer magnetischen Flussdichte einen Extremwert (in Form einer Resonanz) aufweist,
- weitere Mittel zur Erzeugung der weiteren physikalischen Anregung,
- weitere Mittel zur Magnetfelderzeugung, wobei das weitere Material dem erzeugten Magnetfeld ausgesetzt ist, wobei die magnetische Feldstärke einstellbar ist, wobei die weiteren Mittel zur Magnetfelderzeugung angepasst sind, das weitere Material demselben oder einem anderen Magnetfeld auszusetzen wie das erste Material,
- weitere Mittel zur Messung der Lumineszenz bzw. des Photostroms des weiteren Materials mit einem weiteren Erfassungssignal, das die Stärke des erfassten weiteren Lumineszenzsignals bzw. des weiteren Photostromsignals wiedergibt. Dann können sehr einfach Gradienten in einem magnetischen Feld bestimmt werden. Anstelle einer Kombination dieses weiteren Materials und der weiteren Mittel können auch beliebige Kombination hiervon oder auch das weitere Material oder jedes der weiteren Mittel allein eingesetzt werden. Es können auch mehrere weitere Materialien und/oder mehrere weitere Mittel eingesetzt werden.

Die "physikalische Anregung" kann identisch sein mit der "weiteren physikalischen Anregung", so dass auch die "Mittel zur Erzeugung der physikalischen Anregung" identisch sein können mit den "weiteren Mitteln zur Erzeugung der weiteren physikalischen Anregung". Auch die "Mittel zur Magnetfelderzeugung" können mit den "weiteren Mittel zur Magnetfelderzeugung" identisch sein.

In einer vorteilhaften Weiterbildung ist vorgesehen, dass das erste Material und/oder das weitere Material eine Kristallstruktur aufweist mit zumindest einer Fehlstelle, wobei das erste Material bzw. das weitere Material bevorzugt Diamant, Siliziumkarbid oder Silizium ist und die Fehlstelle ein Farbzentrum, insbesondere ein Stickstofffehlstellenzentrum oder ein Stickstofffehlstellenzentrum in Verbindung mit einem Europiumfehlstellenzentrum, einem Vanadiumfehlstellenzentrum oder einem Manganfehlstellenzentrum ist. Bei der Verwendung von Diamant ist auch die Verwendung von ST1 und L2-Zentren denkbar. Bevorzugt handelt es sich um ein fluoreszierendes Material. Diese Materialien weisen sehr gut bekannte Resonanzstellen in ihrer Lumineszenz auf. An dieser Stelle sei auf A. Zaitsev, "Optical Properties of Diamond", 2001, Springer, Berlin, verwiesen, wo zahlreiche geeignete Farbzentren im Diamant angegeben sind. Der Offenbarungsgehalt dieser Veröffentlichung hinsichtlich Farbzentren im Diamant wird hiermit vollumfänglich einbezogen.

In einer vorteilhaften Weiterbildung ist vorgesehen, dass die Mittel zur Erzeugung der physikalischen Anregung bzw. die weiteren Mittel zur Erzeugung der physikalischen Anregung eine elektrische oder eine elektromagnetische Anregung, bevorzugt eine Anregung im optischen Bereich und/oder im Mikrowellenbereich, insbesondere eine LASER-Anregung oder eine LED-Anregung oder eine Anregung durch ionisierende Strahlung bereitstellen. Dadurch lässt sich eine Lumineszenz bzw. ein Photostrom sehr einfach anregen, wobei die Mittel sehr kompakt gehalten werden können. Durch die Verwendung einer Mikrowellenanregung können Feinstrukturen im Lumineszenz- oder Photostromspektrum aufgelöst werden, wodurch die Genauigkeit des erzeugten Referenzwertes noch verbessert werden kann.

Wenn anstelle einer elektromagnetischen Anregung eine elektrische Anregung (beispielsweise mit elektrischen Kontakten) verwendet wird, dann können beispielsweise LEDs für eine optische Anregung entfallen, was entsprechende Sensorik wesentlich kompakter gestaltet. Außerdem bestünde die Möglichkeit, die Ortsauflösung eines entsprechenden Sensors stark zu erhöhen. Genauer gesagt könnte man die Anregung auf einem deutlich kleineren Bereich durch elektrische Kontakte beschränken und würde im Gegensatz zur optischen Detektion nicht Signale aus dem ganzen Material erhalten. Bislang war eine elektrische Anregung daran gescheitert, dass das NV-Zentrum in Diamant ionisiert wurde, allerdings kann dies durch das Anheben des Fermi-Levels, beispielsweise durch eine Phosphor-Dotierung im Diamant, verhindert werden.

In einer vorteilhaften Weiterbildung ist vorgesehen, dass elektrische Kontakte auf dem ersten Material und/oder dem weiteren Material transparent vorliegen. Beispielsweise könnten sogenannte transparente leitfähige Kontakte (TCO - "transparent conducting oxides"), wie Indiumzinnoxid ("ITO"), Fluorzinnoxid, Aluminiumzinkoxid oder Antimonzin noxid, verwendet werden. Diese Kontakte können sowohl im Rahmen der Auslesung des Photostroms als auch für eine elektrische Anregung verwendet werden.

Beispielhafte Methoden der elektrischen Anregungen von Farbzenten in Diamant sind z.B. aus der DE 43 22 830 A1 und aus B. Burchard "Elektronische und optoelektronische Bauelemente und Bauelemente Grundstrukturen auf Diamantbasis", Dissertation, Hagen, 1994 bekannt. Insbesondere kann die Anregung der Lumineszenz durch PIP- oder PIN-Dioden erfolgen. Hierzu sei auch auf B. Tegetmeyer et Al. "Charge state modulation of nitrogen vacancy centers in diamond by applying a forward voltage across a p-i-n junction" Diamond and Related Materials, Volume 65, May 2016, Pages 42-46 und B. Tegetmeyer et Al. "Electroluminescence from silicon vacancy centers in diamond p-i-n diodes" Diamond and Related Materials Volume 65, May 2016, Pages 42-46 beispielhaft verwiesen. Eine Anregung über PN-Dioden ist auch denkbar. Bei der beispielhaften Verwendung von Diamant und einer PIP-Diode injiziert bei Anlegen einer ausreichend hohen Spannung an die PIP-Diode, ein erstes dotiertes Gebiet, beispielsweise ein p+-dotiertes Gebiet, Ladungsträger - hier Löcher -in den intrinsischen Bereich. Dort werden diese durch das elektrische Feld der angelegten Spannung beschleunigt und regen die Farbzentren durch Stöße an, woraufhin diese zu leuchten beginnen. Effizienter ist die Anregung über die Injektion von Elektronen und Löchern, beispielsweise in PIN-Dioden. Durch Bandgap-Engineering oder die Verwendung anderer-Materialien können auch direkte Übergänge erzeugt werden, wobei dann aber andere Farbzentren benutzt werden müssen, da Farbzentren immer materialspezifisch bestehen. Es ist denkbar LEDs, wie die zuvor beschriebenen, nur kapazitiv oder mittels Übertrager oder anders galvanisch getrennt an eine Wechselsignalquelle anzukoppeln. Dies ist insbesondere bei der CMOS-Integration von Vorteil.

In einer vorteilhaften Weiterbildung ist vorgesehen, dass die Mittel zur Magnetfelderzeugung bzw. die weiteren Mittel zur Magnetfelderzeugung zumindest eine Spule umfassen, die durch einen elektrischen Strom anregbar ist, wobei bevorzugt ein magnetischer Leiter, insbesondere in Form eines Jochs mit einem Luftspalt besteht, wobei das erste Material und/oder das weitere Material im Luftspalt angeordnet ist. Dadurch lässt sich das Magnetfeld sehr einfach und dabei zugleich über das erste Material bzw. das weitere Material sehr homogen herstellen. Es können auch Helmholtz-Spulanordnungen eingesetzt werden, die ggf. auch mit einem oder mehreren Jochelementen kombiniert werden können, um eine Konzentration zu erzielen, wobei auch wieder ein Luftspalt verwendbar ist.

In einer vorteilhaften Weiterbildung ist vorgesehen, dass die Mittel zur Messung der Lumineszenz und/oder die weiteren Mittel zur Messung der Lumineszenz einen Fotodetektor umfassen und bevorzugt einen Filter, der die physikalische Anregung dämpft. Dadurch lässt sich die Lumineszenz sehr einfach messen, wobei ohne weiteres eine Miniaturisierung möglich ist.

In einer vorteilhaften Weiterbildung ist vorgesehen, dass die Mittel zur Messung des Photostroms und/oder die weiteren Mittel zur Messung des Photostroms so ausgebildet sind, das eine Spannung zwischen zwei elektrischen Kontakten auf dem ersten Material bzw. dem weiteren Material angelegt und der Photostrom in Serie gemessen wird, wobei die Messung beispielsweise mit einem Lock-in-Verstärker erfolgt oder einfach über den Spannungsabfall an einem bekannten Widerstand. Die Photostrommessung könnte auch mittels Fotodioden und/oder CCD-Elementen und/oder Avalanche-Fotodioden und/oder SPADs (Single-Photon-Avalance-Photodiodes) erfolgen. Eine andere einfache Vorrichtung zur Messung des Photostroms ist aus der DE 10 2010 060 527 B3 bekannt. Bei Verwendung dieser Technologie müssen die Regler getaktet werden. Sie werden dann bevorzugt ganz oder teilweise in Switched-Capacitor-Technik ausgeführt. Dann kann die Messung des Photostroms besonders einfach erfolgen. Insbesondere ist die entsprechende Vorrichtung besonders kompakt aufbaubar.

In einer vorteilhaften Weiterbildung ist vorgesehen, dass die Mittel zur Regelung als stetiger linearer Regler, bevorzugt als PI- oder PID-Regler ausgebildet sind. Dadurch ist eine besonders genaue Regelung auf den Extremwert der Resonanz möglich, was die Genauigkeit und die Stabilität des Referenzwerts zusätzlich verbessert.

In einer vorteilhaften Weiterbildung ist vorgesehen, dass zumindest ein Hochpassfilter zur Filterung des Erfassungssignals und/oder des weiteren Erfassungssignals besteht. Dann kann ein dem Magnetfeld aufgeprägtes hochfrequentes Nutzsignal bestimmt werden, wodurch eine breitbandige Informationsübertragung ermöglicht wird. Außerdem lässt sich auch ein magnetisches Hintergrundfeld sehr genau analysieren.

In einer vorteilhaften Weiterbildung ist vorgesehen, dass zumindest ein Tiefpassfilter zur Filterung des Regelsignals besteht. Dieser Tiefpassfilter kann gesondert bestehen, alle r-dings können auch die Mittel zur Regelung eine solche Tiefpassfilterfunktion bereitstellen. Dadurch wird verhindert, dass hochfrequente Anteile in die Regelung einfließen und in dem Erfassungssignal nicht oder nur verändert vorliegen.

In einer vorteilhaften Weiterbildung ist vorgesehen, dass der Betrag der unteren Grenzfrequenz des Hochpassfilters größer ist als der Betrag der oberen Grenzfrequenz des Tiefpassfilters bzw. der Mittel zur Regelung. Dann ist die breitbandige Informationsübertragung bzw. die Analyse des magnetischen Hintergrundfeldes sehr präzise möglich, wobei insbesondere Störungen in der Regelung des Arbeitspunktes der magnetischen Flussdichte B, die auf das Material einwirkt, verhindert werden. Die Vorrichtung kann dann zum typischerweise sehr breitbandigen Empfang von Nutzsignalen mittels natürlich oder künstlich modulierter elektromagnetischer Strahlung durch Auswertung des Signals der magnetischen Flussdichte eingesetzt werden. Bei natürlich modulierter Strahlung kann es sich beispielsweise um elektromagnetische Felder handeln, die beim Transport von Nervensignalen in Organismen entstehen. Die hier vorgeschlagene Erfindung kann bei geeigneter Gestaltung zur Erfassung solcher biologisch modulierter Signale insbesondere in der Medizintechnik Anwendung finden. Die Vorrichtung und das Verfahren eignen sich daher insbesondere auch zur Elektroenzephalografie.

In einer vorteilhaften Weiterbildung ist vorgesehen, dass die Mittel zur Magnetfelderzeugung zumindest zwei, bevorzugt drei Magnetbereiche aufweisen, die unterschiedliche magnetische Widerstände aufweisen, so dass zumindest zwei, bevorzugt drei Materialbereiche des ersten Materials bzw. des weiteren Materials unterschiedlichen Magnetfeldern ausgesetzt sind, wobei jedem Materialbereich eigene Mittel zur Messung der Lumineszenz bzw. des Photostroms mit einem jeweiligen Erfassungssignal, das die Stärke des erfassten Lumineszenzsignals bzw. Photostromsignals wiedergibt, zugeordnet sind, wobei die Mittel zur Regelung angepasst sind, ein Regelsignal für die Regelung der Mittel zur Magnetfelderzeugung auszugeben und die magnetischen Feldstärke in Abhängigkeit vom Erfassungssignal so zu regeln, dass das Erfassungssignal eines Materialbereichs einen Extremwert annimmt. Dadurch wird für die Mittel zur Regelung ein "Herauslaufen" aus der Resonanzstelle wirksam verhindert. Bevorzugt sind die unterschiedlichen magnetischen Widerstände so eingestellt, dass die sich ergebende Abweichung in der magnetischen Flussdichte B nicht größer ist als der statistische Wert Sigma in der als Gaußfunktion angenäherten Signalkurve in der Resonanzstelle. Insbesondere sollten die magnetischen Widerstände so angepasst sein, dass die sich ergebenden magnetischen Flussdichten im Bereich 0,5 bis 3 mT, bevorzugt 1-2 mT voneinander abweichen. Dann wird eine besonders stabile Regelung erzielt.

In einer vorteilhaften Weiterbildung ist vorgesehen, dass die Mittel zur Magnetfelderzeugung und/oder die weiteren Mittel zur Magnetfelderzeugung eine magnetische Schirmung gegen äußere magnetische Felder aufweisen. Dann ist die erzeugte magnetische Feldstärke unabhängig von äußeren magnetischen Feldern.

In einer vorteilhaften Weiterbildung ist vorgesehen, dass die Mittel zur Erzeugung des Magnetfeldes angepasst sind, ein externes Magnetfeld dem Material zuzuführen. Dann können solche externen Magnetfelder besonders einfach analysiert werden.

In einer vorteilhaften Weiterbildung ist vorgesehen, dass die Mittel zur Erzeugung der physikalischen Anregung angepasst sind, eine Modulation der physikalischen Anregung vorzunehmen, wobei Mittel zur Korrelation der Modulation der physikalischen Anregung mit dem Erfassungssignal bestehen. Dadurch besteht eine sehr präzise und stabile Erzeugung der magnetischen Feldstärke.

Unabhängiger Schutz wird beansprucht für das erfindungsgemäße

Verfahren zur Erzeugung und Regelung einer magnetischen Feldstärke, gekennzeichnet durch die Verwendung:

- eines ersten Material, das bei einer physikalischen Anregung eine Lumineszenz und/oder einen Photostrom erzeugt, wobei die Luminszenz bzw. der Photostrom in Bezug auf ein magnetisches Feld bei zumindest einer magnetischen Flussdichte einen Extremwert (in Form einer Resonanz) aufweist,
- von Mitteln zur Erzeugung der physikalischen Anregung,
- von Mitteln zur Magnetfelderzeugung, wobei das erste Material dem erzeugten Magnetfeld ausgesetzt ist, wobei die magnetische Feldstärke einstellbar ist und
- von Mitteln zur Messung der Lumineszenz bzw. des Photostroms mit einem Erfassungssignal, das die Stärke des erfassten Lumineszenzsignals bzw. des Photostromsignals wiedergibt,

wobei ein Regelsignal für die Regelung der Mittel zur Magnetfelderzeugung ausgegeben wird, um die magnetische Feldstärke in Abhängigkeit vom Erfassungssignal so zu regeln, dass das Erfassungssignal einen Extremwert annimmt.

Selbständiger Schutz wird beansprucht für den erfindungsgemäßen Empfänger zum Empfang von mit einem Nutzsignal modulierten elektromagnetischen Wellen mit zumindest einem Farbzentrum, wobei das Farbzentrum eine Lumineszenz aufweist und wobei die Lumineszenz von einer magnetischen Flussdichte am Ort des Farbzentrums abhängig ist, wobei der Empfänger angepasst ist, das Nutzsignal über diese Lumineszenz zu demodulieren und/oder wobei das Farbzentrum eine Antenne für die modulierten elektromagnetischen Wellen ist. Dadurch kann ein Breitbandempfänger insbesondere für die verschlüsselte Kommunikation bereitgestellt werden.

Weiterhin wird selbständiger Schutz beansprucht für die Verwendung eines Farbzentrum als Antenne als Teilvorrichtung zum Empfang und/oder zur Demodulation eines modulie r-ten elektromagnetischen Signals, insbesondere eines modulierten Nachrichten- oder Messsignals.

Schließlich wird selbständiger Schutz beansprucht für die Verwendung eines Farbzentrum als Antenne als Teilvorrichtung zum Empfang und/oder zur Demodulation eines biologisch modulierten elektromagnetischen Signals, insbesondere eines modulierten Nervensignals.

In einer vorteilhaften Weiterbildung ist vorgesehen, dass die erfindungsgemäße Vorrichtung verwendet wird.

Die Merkmale und weitere Vorteile der vorliegenden Erfindung werden im Folgenden anhand der Beschreibung bevorzugter Ausführungsbeispiele im Zusammenhang mit den Figuren deutlich werden. Dabei zeigen rein schematisch:

Fig. 1a     die Abhängigkeit der Fotolumineszenz eines NV-Zentrums in Diamant von dem Betrag der magnetischen Flussdichte,

Fig. 1b     die Abhängigkeit der ersten Ableitung der Fotolumineszenz eines NV-Zentrums in Diamant von dem Betrag der magnetischen Flussdichte,

Fig. 2     das Grundprinzip, auf dem die vorliegende Erfindung basiert,

Fig. 3     eine alternative Ausgestaltung des Grundprinzips nach Fig. 3,

Fig. 4     die erfindungsgemäße Vorrichtung nach einer ersten bevorzugten Ausgestaltung,

Fig. 5     die erfindungsgemäße Vorrichtung nach einer zweiten bevorzugten Ausgestaltung,

Fig. 6     die erfindungsgemäße Vorrichtung nach einer dritten bevorzugten Ausgestaltung,

Fig. 7     die erfindungsgemäße Vorrichtung nach einer vierten bevorzugten Ausgestaltung,

Fig. 8     die erfindungsgemäße Vorrichtung nach einer fünften bevorzugten Ausgestaltung,

Fig. 9     die erfindungsgemäße Vorrichtung nach einer sechsten bevorzugten Ausgestaltung,

Fig. 10     die planare Umsetzung der sechsten bevorzugten Ausgestaltung nach Fig. 9,

Fig. 11     die erfindungsgemäße Vorrichtung nach einer siebenten bevorzugten Ausgestaltung,

Fig. 12     die erfindungsgemäße Vorrichtung nach einer achten bevorzugten Ausgestaltung,

Fig. 13     einen PI-Regler zur Verwendung in einer der erfindungsgemäßen Vorrichtungen,

Fig. 14     einen Regler zum Einsatz in der erfindungsgemäßen Vorrichtung nach Fig. 3 und

Fig. 15     eine Stromspiegelanordnung zur Verwendung in einer der erfindungsgemäßen Vorrichtungen nach den Fig. 4, 5 oder 7.

Im Folgenden werden identische Bezugszeichen für identische Elemente verwendet.

Farbzentren sind Gitterfehler in Kristallen, die elektromagnetische Strahlung (beispielsweise im UV-, sichtbaren und/oder IR-Bereich) absorbieren. Dadurch entstehen Banden mit einer bestimmten Wellenlänge.

Sehr gut untersucht ist das sogenannte Stickstoff-Fehlstellen-Zentrum (NV - *nitrogen vacancy,* "NV-Zentrum") im Diamant, einer von über 100 bekannten Defekten im Diamant, das dadurch entsteht, dass ein Kohlenstoffatom im Diamantgitter durch ein Stickstoffatom substituiert wird und dessen Nachbaratom fehlt. Bekannt ist der Diamant vom Typ Ib, bei dem diese NV-Zentren über die gesamte Diamantstruktur gleichmäßig verteilt vorliegen.

Die Fotolumineszenz dieses NV-Zentrums ist stark von dem magnetischen Fluss eines magnetischen Feldes abhängig, dass auf das NV-Zentrum einwirkt.

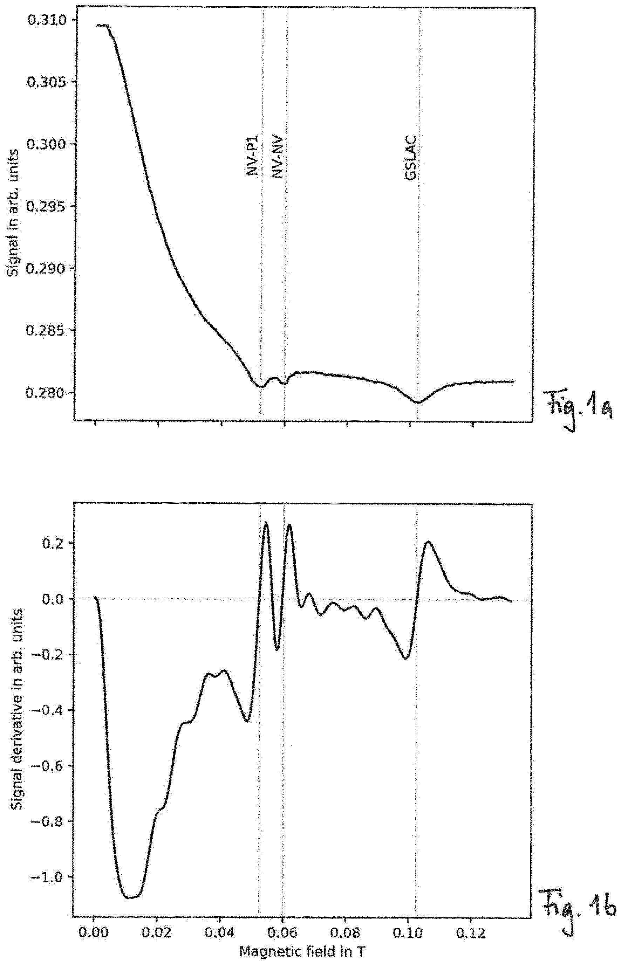

Fig. 1a und 1b zeigen die Fotolumineszenz bzw. die erste Ableitung der Fotolumineszenz eines solchen NV-Zentrums in Diamant in Abhängigkeit von dem Betrag der magnetischen Flussdichte, wobei das Feld in der NV-Achse ausgerichtet ist. Bei einer Flussdichte von |B|=102,4 mT nimmt die Fotolumineszenz ein Minimum an. Diese Flussdichte wird auch "GSLAC-Flussdichte" (GSLAC - *Ground State Level Anti Crossing*) genannt. Die Theorie sagt voraus, dass die Fotolumineszenz hier ein deutliches Minimum haben sollte. Das Minimum ist extrem scharf und weist einen Kontrast von mehr als 4,5% auf, was die Sensitivität maximiert. Außerdem hängt dieser Punkt nicht von Umweltparametern ab, was ein wesentlicher Vorteil ist. (Theoretisch gibt es zwar Abhängigkeiten von einem externen E-Feld, dem Druck und der Temperatur. Da diese Abhängigkeiten aber sehr schwach sind, sind sie vernachlässigbar.)

Außerdem bestehen bei ca. 60 mT die NV-NV-Resonanz und bei etwa 51,2 mT die NV-P1-Resonanz.

Die Lumineszenz negativ geladener NV-Zentren findet in einem Wellenlängenbereich von 600- 800 nm statt mit einer Null-Phononen-Linie bei 638 nm. Angeregt werden kann das NV- Zentrum mit Wellenlängen kleiner-gleich 638 nm. Mittels eingeprägter mechanischer Spannungen im Kristall (beispielsweise durch Kavitäten oder einen hohen Druck) ist es möglich, die notwendigen Anregungsenergien zu verschieben, sowie die Lumineszenz-Charakteristik zu verändern.

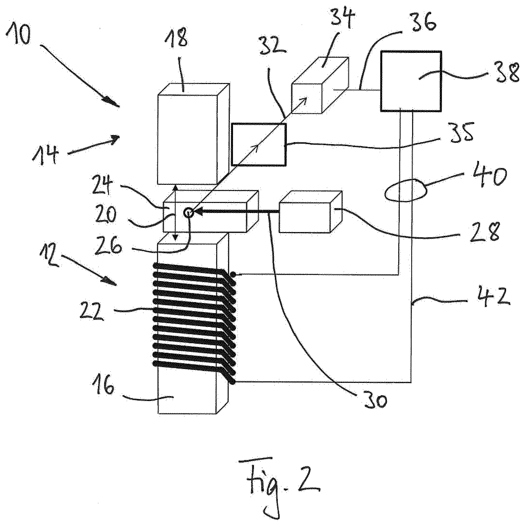

In Fig. 2 ist der elektrische Regelkreis 10 des Grundprinzips der vorliegenden Erfindung dargestellt. Es ist zu erkennen, dass der Regelkreis 10 einen magnetischen Teilkreis 12 aufweist, der beispielhaft eine Jochanordnung 14 aus beispielsweise zwei Kernen 16, 18 aus vorzugsweise ferromagnetischen Material (beispielsweise einem Eisenkern) umfasst, zwischen denen ein Luftspalt 20 angeordnet ist. Der erste Kern 16 ist beispielsweise mit einer Spule 22 mit einer bestimmten Windungszahl umwickelt, die zur magnetischen Erregung des magnetischen Teilkreises 12 dient.

In dem Luftspalt 20 befindet sich beispielsweise ein Diamant 24 vom Typ Ib mit einem NV-Zentrum 26 als lumineszierendes Material, der von einer LASER-Diode 28 mit elektromagnetscher Strahlung 30 einer ersten Wellenlänge bestrahlt wird, die ausreichend ist, die Fotolumineszenz im Diamant 24 anzuregen. Das NV-Zentrum 26 emittiert dann elektromagnetische Strahlung 32 einer zweiten Wellenlänge, die von der ersten Wellenlänge verschieden ist. Beispielsweise beträgt die erste Wellenlänge 532 nm und die zweite Wellenlänge liegt im Bereich zwischen 600 und 800 nm.

Weiterhin besteht ein Fotodetektor 34, der die emittierte Strahlung 32 empfängt. Um die elektromagnetische Strahlung 30 der ersten Wellenlänge aus dem Empfangspfad für die elektromagnetische Strahlung 32 der zweiten Wellenlänge herauszuhalten, ist in den Emissionspfad ein optischer Filter 35 eingefügt, der die elektromagnetische Strahlung 30 der ersten Wellenlänge nicht durchlässt oder zumindest ausreichend dämpft und der die elektromagnetische Strahlung 32 der zweiten Wellenlänge durchlässt oder zumindest ausreichend ungedämpft transmittiert. Es können auch weitere optische Komponenten, wie Strahlteiler und dgl. im optischen Strahlengang bei Bedarf vorgesehen sein.

Der Fotodetektor 34 erfasst die elektromagnetische Strahlung 32 der zweiten Wellenlänge und erzeugt ein Erfassungssignal 36 in Abhängigkeit von dieser erfassten elektromagnetischen Strahlung 32 der zweiten Wellenlänge des NV-Zentrums 26. Der Wert des Erfassungssignals 36 ist bevorzugt proportional zum Amplitudenbetrag der Energieintensität der elektromagnetischen Strahlung 32 der zweiten Wellenlänge. Zumindest ist aber das Erfassungssignal 36 von der Energieintensität der elektromagnetischen Strahlung 32 der zweiten Wellenlänge abhängig.

Schließlich ist ein Regler 38 vorgesehen, der aus dem Erfassungssignal 36 das Regelsignal 40 zur Ansteuerung der Spule 22 über den elektrischen Leiter 42 erzeugt. Die durch die Spule 22 erzeugte magnetische Erregung hängt somit vom Regelsignal 40 ab. Die Regelung des Reglers 38 wird dabei so gewählt, dass die Emission von elektromagnetischer Strahlung 32 der zweiten Wellenlänge durch das erste NV-Zentrum 26 minimiert wird. Dabei ist der Regler beispielsweise ein PI- oder PID-Regler bekannter Art, wobei ein PID-Regler bevorzugt wird, bei dem auf den Nullpunkt der Ableitung des vom Fotodetektor 34 gemessenen Erfassungssignals geregelt wird. Bei der Ableitung kann es sich um die erste oder zweite Ableitung des Erfassungssignals handeln.

Bei geeigneter magnetischer Abschirmung (nicht gezeigt) des Diamanten 24 ist das Regelsignal 40 nur abhängig von den geometrischen Parametern des magnetischen Teilkreises 12, so dass das Regelsignal 40 als Basis für einen physikalischen Referenzwert genommen werden kann. Aber auch wenn keine magnetische Abschirmung besteht, kann das Regelsignal 40 als Basis für einen physikalischen Referenzwert genommen werden, nämlich dann, wenn die Größe eines externen, beispielsweise des Erdmagnetfeldes bekannt ist. Durch ein solches externes Magnetfeld kann das Regelsignal 40 gezielt verringert werden, was für bestimmte Anwendungsfälle sinnvoll ist. In jedem Fall liefert der Regelkreis 10 eine magnetische Feldstärke H durch Anregung der Spule 22.

Zur Verdeutlichung wird angenommen, dass die Lumineszenz L um die Resonanzstelle herum durch die Funktion

$$L = L_0 \left[ 1 - e^{-\frac{(B-B_0)^2}{\sigma^2}} \right]$$

angenähert wird. Hierbei ist die Flussdichte $B_0$ die Position der Resonanzstelle und $\sigma$ deren Breite. Zu Beginn der Regelung sollte ein Startwert für die magnetische Flussdichte B eingenommen werden, der sicherstellt, dass die Regelung in Richtung Lumineszenzextremum verläuft.

Knapp unterhalb der Resonanzstelle ist die Empfindlichkeit

$$\frac{\partial L}{\partial B} = -2 \frac{B-B_0}{\sigma^2} e^{-\frac{(B-B_0)^2}{\sigma^2}}.$$

Damit lässt sich die Lumineszenz in Abhängigkeit von der magnetische Flussdichte B knapp unterhalb der Resonanzstelle $B_0$ an einer Stelle $B_k$ bei einer Flussdichteabweichung $\Delta B$ abschätzen als

$$L \sim L_0 - 2 \frac{B_k - B_0}{\sigma^2} e^{-\frac{(B_k - B_0)^2}{\sigma^2}} \Delta B.$$

Damit erhält man als Pegel $P_{36}$ des Erfassungssignals 36 des Fotodetektors 34 unter der Voraussetzung, dass dieser einen Wert proportional zur Intensität der Lumineszenz L liefert:

$$P_{36} \sim k \left( L_0 - 2 \frac{B_k - B_0}{\sigma^2} e^{-\frac{(B_k - B_0)^2}{\sigma^2}} \Delta B \right).$$

Dabei ist keine Proportionalitätskonstante. Der Regler 38 liefert dann einen elektrischen Strom der proportional zum Pegel $P_{36}$ des Erfassungssignals 36 des Fotodetektors 34 ist. Die integrierende Eigenschaft des bevorzugt als PI-Regler ausgebildeten Reglers 38 wird hier zur Vereinfachung weggelassen und nur eine Variante mit P-Regler beschrieben.

Das Regelsignal $R_{40}$ wird dann beschrieben als:

$$R_{40} \sim f * k * \left( L_0 - 2 \frac{B_k - B_0}{\sigma^2} e^{-\frac{(B_k - B_0)^2}{\sigma^2}} \Delta B \right).$$

Hierbei ist f eine weitere Konstante des Reglers, typischerweise die Verstärkung. Das Vorzeichen von -f wird bevorzugt so gewählt, dass später die Veränderung $\Delta B$ kompensiert wird, damit sich Stabilität einstellt. Die Spule 22 setzt das Regelsignal 40 in eine zusätzliche magnetische Erregung H um, die als zusätzlicher magnetischer Fluss $\Delta B_L$ wieder auf das NV-Zentrum 26 einwirkt. Es ergibt sich somit

$$\Delta B_L \sim g * f * k * \left( L_0 - 2 \frac{B_k - B_0}{\sigma^2} e^{-\frac{(B_k - B_0)^2}{\sigma^2}} (\Delta B + \Delta B_L) \right)$$

Auflösen nach $\Delta B_L$ ergibt:

$$\Delta B_L \sim \frac{g*f*k*\left(L_0 - 2\frac{B_k - B_0}{\sigma^2}e^{-\frac{(B_k - B_0)^2}{\sigma^2}}\right)}{1 - g*f*k*\left(L_0 - 2\frac{B_k - B_0}{\sigma^2}e^{-\frac{(B_k - B_0)^2}{\sigma^2}}\right)}\Delta B$$

Dies kann geschrieben werden als:

$$\Delta B_L \sim \frac{1}{\cfrac{1}{g*f*k*\left(L_0 - 2\frac{B_k - B_0}{\sigma^2}e^{-\frac{(B_k - B_0)^2}{\sigma^2}}\right)} - 1}\Delta B$$

Nun wird die Verstärkung sehr hoch, bevorzugt im Bereich um $10^{10}$ oder höher eingestellt. Dann vereinfacht sich die Gleichung bei richtiger Wahl des Vorzeichens von -f zu:

$$\Delta B_L \sim \Delta B$$

Damit gilt dann aber auch

$$R_{40} \sim f*k*\left(L_0 - 2\frac{B_k - B_0}{\sigma^2}e^{-\frac{(B_k - B_0)^2}{\sigma^2}}\Delta B_L\right).$$

Das Regelsignal ist damit differentiell proportional zu der in dem NV-Zentrum 26 überlagerten zusätzlichen Flussdichte $\Delta B_L$. Damit kann das Regelsignal 40 als Maß für eine zusätzliche überlagerte magnetische Flussdichte $\Delta B_L$ verwendet werden.

Durch Kombination eines NV-Zentrums mit unterschiedlichen paramagnetischen Zentren NV-EuV, NV-NV, NV-MgV können verschiede Kalibrationspunkte erzeugt und ausgelesen werden. Beispielhaft für weitere geeignete Zentren sein das St1- oder auch das L2-Zentrum genannt. Das St1-Zentrum besitzt eine Emissionslinie von 581 nm und muss mit Licht höheren Energien als das NV-Zentrum angeregt werden.

Des Weiteren ist es möglich, geeignete Spin-Systeme in Form geeigneter Farbzentren in SiC und Si an Stelle des Diamants 24 und des NV-Zentrums in Diamant 24 zu erzeugen.

Durch die Wahl geeigneter Materialien und deren Fehlstellen sowie geeignete Wahl der Parameter des magnetischen Teilkreises 12 können damit die erforderliche magnetische Flussdichte und damit auch das erforderliche Regelsignal 40 gezielt gewählt werden.

Da die magnetische Flussdichte je nach Regelalgorithmus bevorzugt linear vom Regelsignal 40 abhängig ist, muss somit nur einmal eine Kalibration dieses Regelsignals in Bezug auf die tatsächlichen Parameter des magnetischen Teilkreises 12, also insbesondere den Windungsdurchmesser, die Zahl der Windungen, die Leiterstärke und die Jochanordnung 14 vorgenommen werden. Bei hochgenauen Fertigungstechniken, wie beispielsweise mikrotechnischen Fertigungsverfahren kann die Kalibration ggf. sogar entfallen.

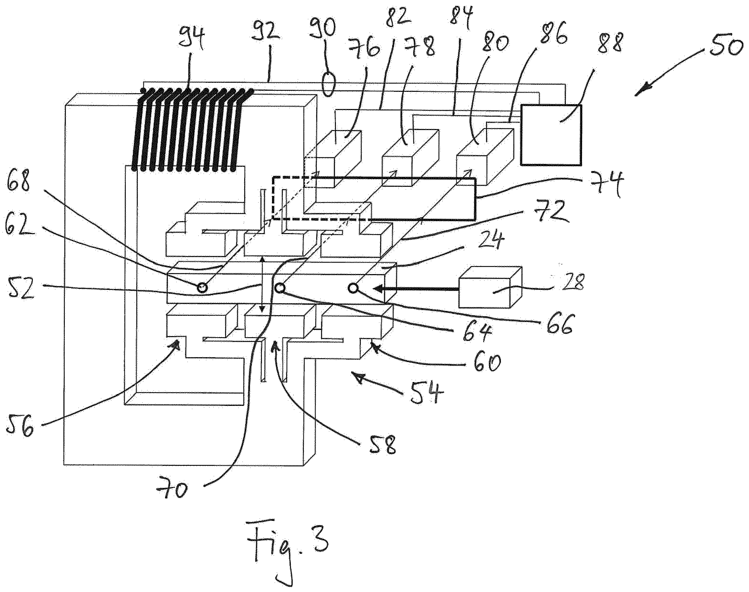

Fig. 3 zeigt eine alternative Ausgestaltung des erfindungsgemäßen Regelkreises 50.

Es ist zu erkennen, dass hier wiederum ein lumineszierendes Material 24 im Luftspalt 52 einer Jochanordnung 54 angeordnet ist und von einer LASER-Diode 28 bestrahlt wird.

Im Unterschied zum Regelkreis 10 nach Fig. 2 ist hier die Jochanordnung 54 bis auf den Luftspalt 52 geschlossen ausgebildet, wobei allerdings drei unterschiedliche, parallel zueinander angeordnete Magnetbereiche 56, 58, 60 am Luftspalt 52 bestehen. Jeder dieser Magnetbereiche 56, 58, 60 beeinflusst unterschiedliche NV-Zentren 62, 64, 66 im Diamant 22, wodurch nach Anregung durch die LASER-Diode 28 mit einer elektromagnetische Strahlung 30 einer ersten Wellenlänge unterschiedliche elektromagnetische Strahlungen 68, 70, 72 einer zweiten Wellenlänge abgegeben werden. Es besteht wiederum ein Filter 74 für die elektromagnetische Strahlung 30 der ersten Wellenlänge und jede elektromagnetische Strahlung 68, 70, 72 der zweiten Wellenlänge wird von einem jeweils zugeordneten Fotodetektor 76, 78, 80 empfangen und die entsprechenden Erfassungssignale 82, 84, 86 werden als Eingangssignale einem PID-Regler 88 zugeleitet, der ein Regelsignal 90 über den elektrischen Leiter 92 zur Erzeugung einer elektrischen Feldstärke mittels der Spule 94 abgibt.

Die Magnetbereiche 56, 58, 60 sind so ausgebildet, dass sie jeweils unterschiedliche magnetische Widerstände besitzen. Genauer gesagt, sind beispielsweise die Magnetbereiche 56, 58, 60 so ausgebildet, dass der magnetische Fluss B im Spalt 52 für den Magnetbereich 58 einen Wert B, für den Magnetbereich 56 einen Wert B - 1 mT und für den Magnetbereich 60 einen Wert B + 1 mT aufweist.

Dadurch wird eine multidimensionale Regelung realisiert, die verhindert, dass der Regler 88 außerhalb des eigentlichen Nulldurchgangs der ersten Ableitung der GSLAC-Resonanzstelle läuft. Durch die voneinander beabstandeten Flussdichten der unterschiedlichen Magnetbereiche 56, 58, 60 erkennt der Regler 88 immer, wo er sich im Bereich der Resonanzstelle befindet. Der Abstand der erzeugten magnetischen Flussdichten beträgt dabei bevorzugt nicht mehr als die Breite der Resonanzstelle, also 1 $\sigma$. Der Wert von $\pm$ 1 mT kann also auch unterschiedlich gewählt werden, allerdings sollte er nicht größer als 1 $\sigma$ sein. Bevorzugt werden dabei diese Abstände symmetrisch zu einem Symmetriepunkt gewählt.

Es können auch nur zwei solcher Magnetbereiche verwendet werden, allerdings sind drei Magnetbereiche 56, 58, 60 bevorzugt, weil sich dann die zweite Ableitung des Erfassungssignals, hier der Lumineszenzkurve, bilden lässt. Dann kann man auf Nulldurchgänge in dieser zweiten Ableitung, also Maxima bzw. Minima in der ersten Ableitung regeln, wobei die höchste Regelempfindlichkeit besteht.

Diese Ausgestaltung nach Fig. 3 kann grundsätzlich in allen im Folgenden beschriebenen Vorrichtungen 100, 200, 300, 400, 500, 600, 700, 800 vorteilhaft eingesetzt werden.

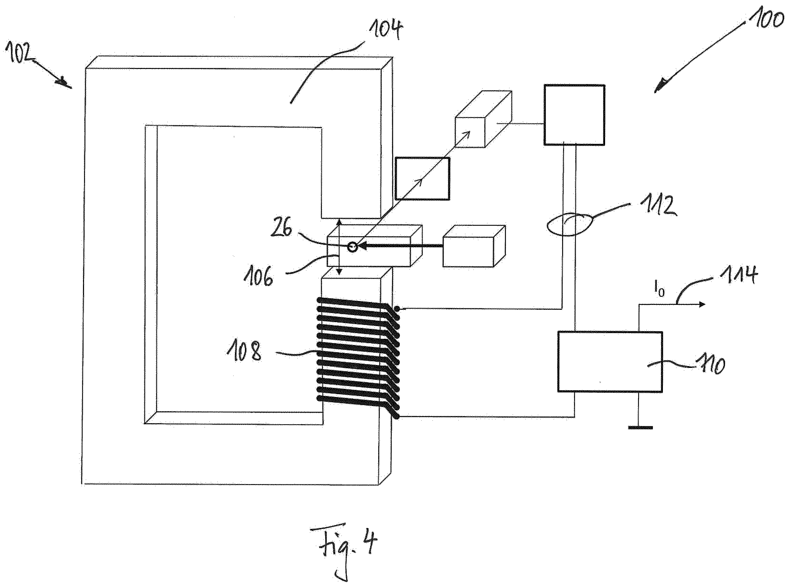

Fig. 4 zeigt eine erste bevorzugte Ausgestaltung der erfindungsgemäßen Vorrichtung 100.

Es ist zu erkennen, dass diese Vorrichtung im Wesentlichen den Regelkreis 10 nach Fig. 2 aufweist mit der Ausnahme, dass anstelle des magnetischen Teilkreises 12 mit den beiden Kernen 16, 18 hier ein magnetischer Kreis 102 mit einem durchgehenden magnetischen Joch 104 mit dem Luftspalt 106 gewählt wurde, wodurch das durch die Spule 108 induzierte Magnetfeld im Luftspalt 106 besonders homogen ist.

Im Übrigen weist die Vorrichtung 100 einen elektrischen Stromspiegel 110 auf, wodurch der durch das Regelsignal 112 bereitgestellte elektrische Strom für die Spule 108 in einen Ausgangsstrom 114 ($I_0$) gewandelt wird. Wird die Vorrichtung 100 ausreichend gegen Einstrahlung magnetischer und elektromagnetischer Felder von außen abgeschirmt, so ist der Betrag $|I_0|$ dieses Stromes 114 unabhängig von Umgebungsparametern. Die Vorrichtung 100 ist daher als hochgenaue Referenzstromquelle geeignet. Durch Einstellung unterschiedlicher Spiegelverhältnisse können sehr leicht andere Referenzstromwerte eingestellt werden, die dann nur von den Verhältnissen der Transistorflächen innerhalb des Stromspiegels 110 bestimmt werden. Hinsichtlich der Schaltungstechnik sei hier beispielhaft auf Tietze, Schenk, "Halbleiter-Schaltungstechnik", Springer verwiesen.

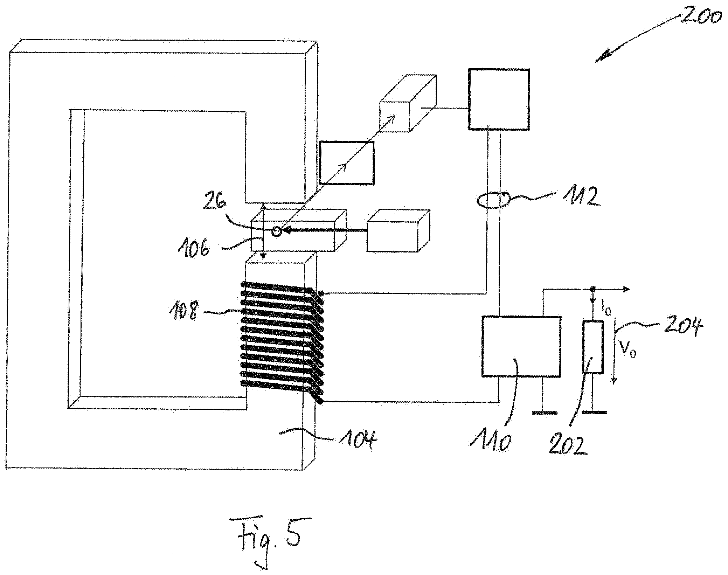

Fig. 5 zeigt eine zweite bevorzugte Ausgestaltung der erfindungsgemäßen Vorrichtung 200.

Es ist zu erkennen, dass dabei gegenüber der Vorrichtung 100 nach Fig. 4 eine Modifikation dahingehend besteht, dass zusätzlich zum Stromspiegel 110 ein Widerstand 202 als Quellenwiderstand verwendet wird. Durch diesen Quellenwiderstand 202 (Rq) wird der Ausgangsstrom 114 in eine Referenzspannung 204 ($V_0$) gewandelt. Die Vorrichtung 200 kann daher als eine hochgenaue Referenzspannungsquelle mit Innenwiderstand (Rq) angesehen werden. Durch geeignete Wahl bzw. Anpassung des Quellenwiderstands 202 und/oder geeignete Einstellung des Verhältnisses des Stromspiegels 110 kann der Wert der Referenzspannung 204 exakt festgelegt werden.

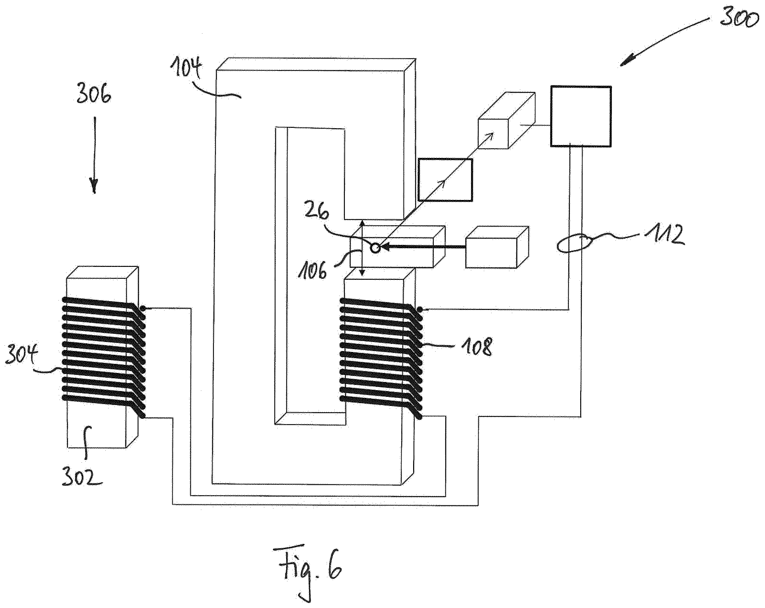

Fig. 6 zeigt eine dritte bevorzugte Ausgestaltung der erfindungsgemäßen Vorrichtung 300.

Es ist zu erkennen, dass hier im Gegensatz zur Vorrichtung 100 nach Fig. 4 kein Stromspiegel verwendet wurde, sondern eine zweite, um einen Kern 302 gewickelte Spule 304 zur ersten Spule 108 in Reihe geschaltet wurde.

Durch Wahl der Geometrie der zweiten Spule 304 und der Anzahl ihrer Spulenwindungen und der Materialien des Kerns 302 kann das Magnetfeld dieses zweiten magnetischen Kreises 306 gezielt eingestellt werden. Gegebenenfalls kann durch einen Stromteiler (nicht gezeigt) der Erregungsstrom der zweiten Spule 304 gezielt eingestellt und ggf. angepasst werden.

Diese Vorrichtung 300 stellt somit eine hochgenaue Referenzquelle für ein magnetisches Feld und zwar für eine magnetische Feldstärke H, die durch den magnetischen Teilkreis 306 erzeugt wird, dar. Anstelle eines solchen magnetischen Teilkreises 306 können natürlich auch magnetische Kreise eingesetzt werden. Hinsichtlich der Konstruktion und Verwendung magnetischer Kreise sein beispielhaft auf Küpfmüller, Theoretische Elektrotechnik Elektromagnetische Felder, Schaltungen und elektronische Bauelemente, Springer verwiesen.

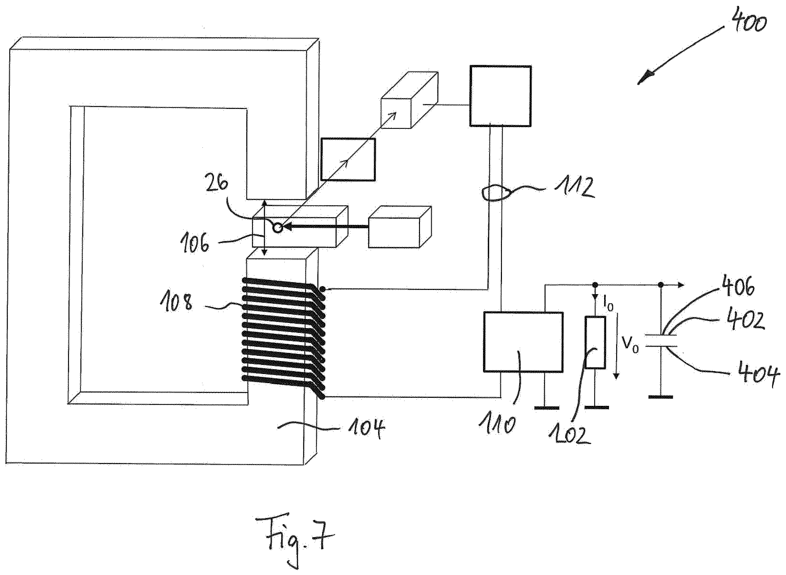

Fig. 7 zeigt eine vierte bevorzugte Ausgestaltung der erfindungsgemäßen Vorrichtung 400.

Es ist zu erkennen, dass hier im Gegensatz zur Vorrichtung 200 nach Fig. 4 zusätzlich zu dem Quellenwiderstand 202 ein Kondensator 402 parallel geschaltet ist, wodurch sich der Kondensator 402 solange auflädt, bis dessen Spannung identisch zur Spannung $V_0$ über dem Quellenwiderstand 202 ist.

Durch Wahl der Geometrie des Kondensators 402 und seiner Materialien kann das elektrische Feld zwischen den Kondensatorplatten 404, 406 gezielt eingestellt werden. Gegebenenfalls kann durch einen Spannungsteiler (nicht gezeigt) die Erregungsspannung des Kondensators 402 gezielt eingestellt und ggf. angepasst werden.

Diese Vorrichtung 400 stellt somit eine hochgenaue Referenzquelle für ein elektrisches Feld innerhalb des Kondensators 402 dar.

Andererseits könnte auch der Quellenwiderstand 202 weggelassen werden, wodurch sich eine Spannungsrampe über den Kondensator 402 aufbaut, die eine Referenzzeit bzw. eine Referenzfrequenz liefern kann.

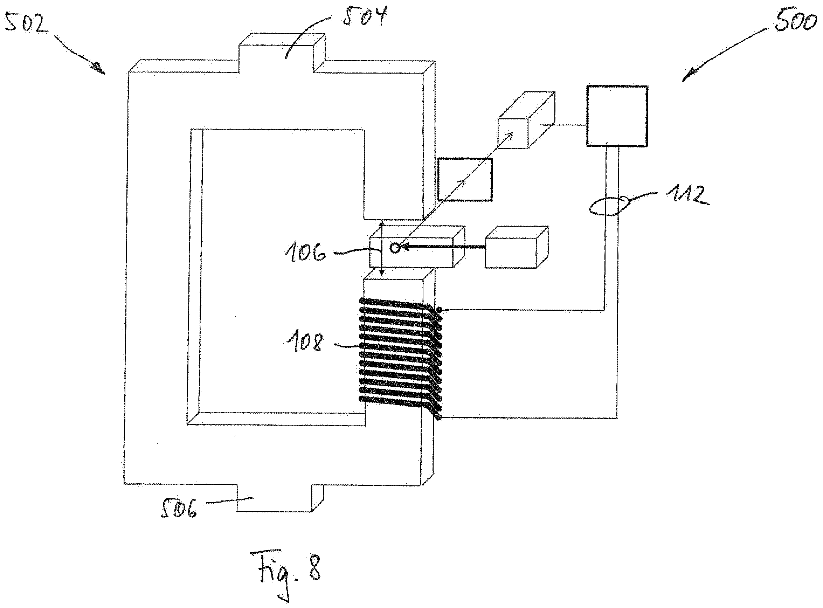

Fig. 8 zeigt eine fünfte bevorzugte Ausgestaltung der erfindungsgemäßen Vorrichtung 500.

Es ist zu erkennen, dass hier im Gegensatz zum Regelkreis 10 prinzipiell ein magnetischer Kreis 502 entsprechend Fig. 4 verwendet wird, wobei allerdings zusätzliche Elemente 504, 506 zum Einleiten eines externen magnetischen Feldes bestehen.

Durch das externe magnetische Feld wird die durch die Spule 108 erzeugte magnetische Feldstärke mit einer externen magnetischen Feldstärke überlagert, wodurch die magnetische Flussdichte im Spalt 106 definiert wird. Aus dem Regelsignal 112 kann dadurch die externe magnetische Feldstärke berechnet werden.

Dadurch kann diese Vorrichtung 500 zur exakten Bestimmung einer eingespeisten, externen magnetischen Feldstärke verwendet werden.

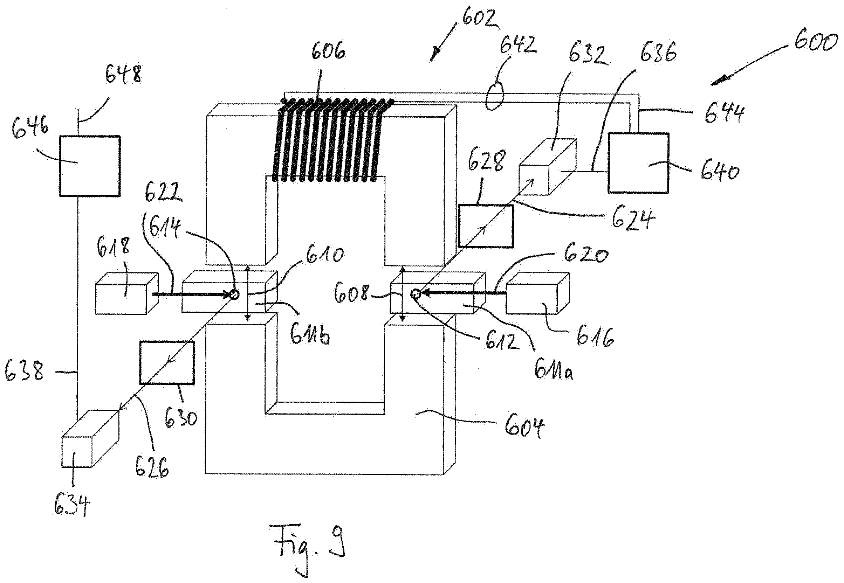

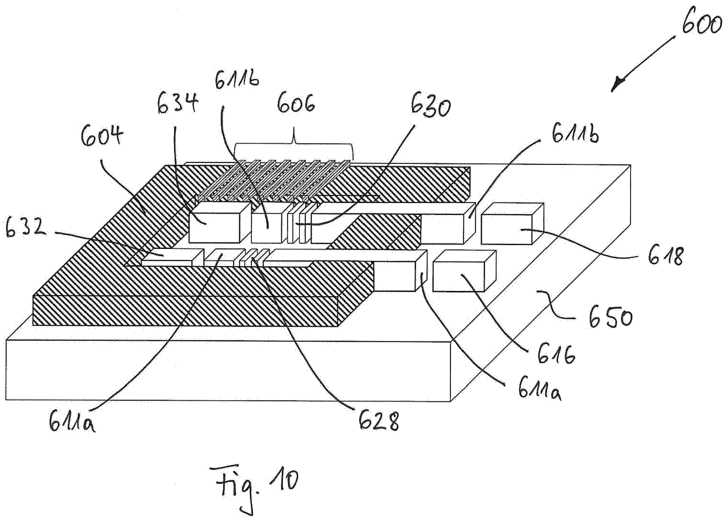

Die Fig. 9 und 10 zeigen eine sechste bevorzugte Ausgestaltung der erfindungsgemäßen Vorrichtung 600.

Es ist zu erkennen, dass auch hier wieder ein magnetischer Kreis 602 besteht der durch eine Jochanordnung 604 und eine Spule 606 gebildet wird, wobei in der Jochanordnung zwei Luftspalte 608, 610 bestehen. In jedem der Luftspalte befindet sich ein Diamant 611a, 611b mit jeweiligen NV-Zentren 612, 614, die jeweils von LASER-Dioden 616, 618 mit elektromagnetischer Strahlung 620, 622 einer ersten Wellenlänge angeregt werden.

Die von dem jeweiligen Diamant 611a, 611b mit NV-Zentren 612, 614 emittierte elektromagnetische Strahlung 624, 626 einer zweiten Wellenlänge wird durch einen Filter 628, 630 geleitet, um auf die elektromagnetische Strahlung 620, 622 der ersten Wellenlänge zu filtern.

Fotodetektoren 632, 634 erfassen die jeweilige elektromagnetische Strahlung 624, 626 der zweiten Wellenlänge und erzeugen ein jeweiliges Erfassungssignal 636, 638 in Abhängigkeit von dieser erfassten elektromagnetischen Strahlung 624, 626 der zweiten Wellenlänge der NV-Zentrumen 612, 614. Der Wert der Erfassungssignale 636, 638 ist bevorzugt proportional zum Amplitudenbetrag der Energieintensität der jeweiligen elektromagnetischen Strahlung 624, 626 der zweiten Wellenlänge. Zumindest ist aber das Erfassungssignal 636, 638 von der Energieintensität jeweiligen der elektromagnetischen Strahlung 32 der zweiten Wellenlänge abhängig.

Auf der Seite des ersten NV-Zentrums 612 ist schließlich ein Regler 640 vorgesehen, der aus dem Erfassungssignal 636 das Regelsignal 642 zur Ansteuerung der Spule 606 über den elektrischen Leiter 644 erzeugt. Die durch die Spule 606 erzeugte magnetische Erregung hängt somit vom Regelsignal 642 ab. Die Regelung des Reglers 640 wird dabei wiederum so gewählt, dass die Emission von elektromagnetischer Strahlung 624 der zweiten Wellenlänge durch das erste NV-Zentrum 612 minimiert wird. Dabei ist der Regler beispielsweise ein PI- oder PID-Regler bekannter Art, wobei ein PID-Regler bevorzugt wird, bei dem auf den Nullpunkt der Ableitung des vom Fotodetektor 632 gemessenen Erfassungssignals geregelt wird. Bei der Ableitung kann es sich um die erste oder zweite Ableitung des Erfassungssignals handeln.

Da das zweite NV-Zentrum 614 identisch zum ersten NV-Zentrum 612 ist und auch die anderen magnetischen Komponenten, insbesondere der magnetische Widerstand im Luftspalt 610, prinzipiell identisch ausgebildet sind, ist zu erwarten, dass die magnetische Flussdichte B in beiden Luftspalten 608, 610 identisch ist und somit auch für das Erfassungssignal 638 des zweiten NV-Zentrums 614 ein Minimum besteht.

Aufgrund von Magnetfeldgradienten eines Hintergrundfeldes, wie dem Erdmagnetfeld, kommt es allerdings zu einer Abweichung vom Minimum des Erfassungssignals 638. Aus der Größe dieser Abweichung und dem Abstand der beiden NV-Zentren 612, 164 kann somit direkt auf diesen Gradienten der magnetischen Flussdichte des Hintergrundfeldes geschlossen werden. Dabei muss nur einmal eine Kalibration in Bezug auf die Stärke der Magnetfeldabweichung in Bezug auf das Erfassungssignal 638 für das zweite NV-Zentrum 614 vorgenommen werden. Da zu erwarten ist, dass die durch den Gradienten bedingten Abweichungen im Magnetfeld nur sehr gering sind über den Abstand der beiden NV-Zentren 612, 614, ist zusätzlich noch ein Messverstärker 646 vorgesehen, der ein entsprechendes Messsignal 648 ausgibt, das zur Analyse des Magnetfeldgradienten verwendet werden kann. Diese Ausgestaltung der Vorrichtung 600 kann somit zur hochgenauen Bestimmung eines Gradienten im Hintergrundmagnetfeld verwendet werden.

In Fig. 10 ist eine planare Ausführung der Vorrichtung 600 gezeigt. Es ist zu erkennen, dass alle Elemente auf einem planaren Substrat 650 angeordnet sind. Diese planare Struktur kann CMOS-kompatibel hergestellt werden, wobei für die Erzeugung insbesondere der Lichtquellen (bevorzugt LASER-Dioden) 616, 618 auf die DE 100 00 707 A1 hingewiesen wird, deren diesbezüglicher Offenbarungsgehalt vollumfänglich einbezogen wird.

Wenn eine magnetische Schirmung (nicht gezeigt) des ersten NV-Zentrums 612 besteht, dann besteht kein Einfluss des magnetischen Hintergrundes auf die Flussdichte B im Luftspalt 608. Dadurch wird nur die magnetische Flussdichte B im Luftspalt 610 vom magnetischen Hintergrund bestimmt, so dass das Erfassungssignal 638 ein Maß für das Hintergrundmagnetfeld ist. Diese alternative Ausgestaltung der Vorrichtung 600 kann somit zur hochgenauen Bestimmung eines Hintergrundmagnetfeldes verwendet werden.

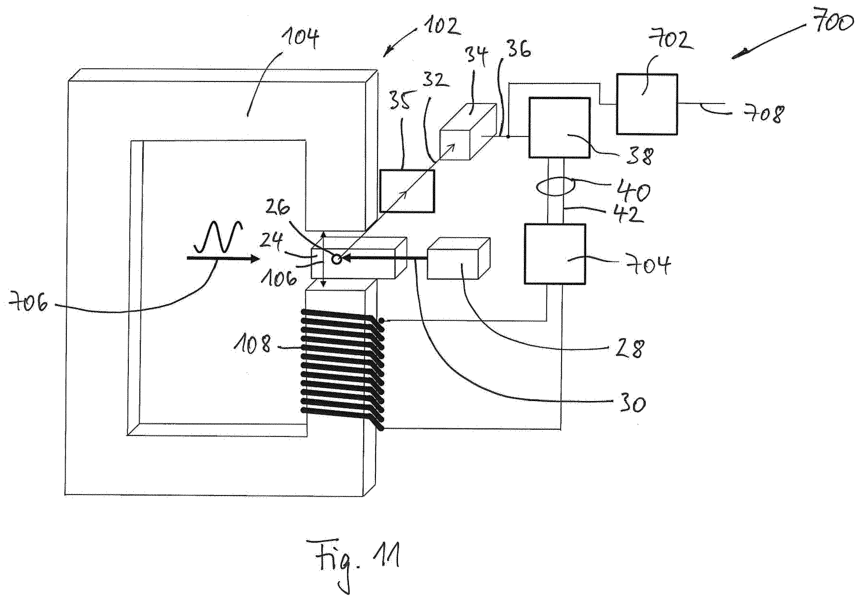

Fig. 11 zeigt eine siebente bevorzugte Ausgestaltung der erfindungsgemäßen Vorrichtung 700.

Es ist zu erkennen, dass hier wiederum wie bei der Vorrichtung 100 nach Fig. 4 ein magnetischer Kreis 102 mit einem Joch 104 besteht, in deren Luftspalt 106 ein Diamant 24 mit einem NV-Zentrum 26 angeordnet ist.

Das NV-Zentrum 26 wird wiederum von einer LASER-Diode 28 mit elektromagnetischer Strahlung 30 der ersten Wellenlänge angeregt, wodurch das NV-Zentrum 26 eine elektromagnetische Strahlung 32 der zweiten Wellenlänge emittiert. Diese Strahlung wird wiederum gefiltert 35 und einem Fotodetektor 34 zugeführt, der das Erfassungssignal 36 ausgibt. Dieses Erfassungssignal 36 wird dem PID-Regler 38 zugeführt, der das Regelsignal 40 über die Stromleitung 41 an die Spule 108 ausgibt.

Zusätzlich besteht hier ein Hochpassfilter 702 mit einer unteren Grenzfrequenz $f_{gu}$ für die Transmission. Der Regler 38 selbst oder ein optional vorgesehener Tiefpassfilter 704 weisen eine obere Grenzfrequenz $f_{go}$ für die Transmission auf. Diese obere Grenzfrequenz $f_{go}$ ist kleiner als die untere Grenzfrequenz des Hochpassfilters 702, um dadurch Störungen in der Regelung des Arbeitspunktes der magnetischen Flussdichte B , die auf das NV-Zentrum 26 einwirkt, zu verhindern.

Wenn nun ein elektromagnetisches Wechselfeld 706, beispielsweise ein moduliertes Magnetfeld, eingestrahlt wird und auf das NV-Zentrum 26 wirkt, dann folgen die beteiligten Atome bzw. Fehlstellen diesem Wechselfeld 706 und die emittierte Fluoreszenz 32 wird ebenfalls einer Modulation mit einer Frequenz unterliegen, die der Frequenz des Wechselfeldes 706 entspricht.

Durch den Regler 38 und dessen Tiefpasscharakteristik bzw. den zusätzlichen Tiefpassfilter 704 erfolgt keine Regelung auf diese Modulation in der Fluoreszenz, wenn die Frequenz der Modulation größer ist als die untere Grenzfrequenz $f_{gu}$ des Hochpassfilters 702, so dass nur die Grundfluoreszenz durch den Regler 38 auf ein Minimum geregelt wird, die Modulation jedoch bestehen bleibt. Die damit bedingte hochfrequente Modulation des Erfassungssignals 36 wird durch den Hochpassfilter 702 ausgelesen und als Nutzsignal 708 ausgegeben.

Damit steht mit der Vorrichtung 700 eine hochempfindliche Antenne für das magnetische Wechselfeld 706 zur Verfügung. Aufgrund des Aufbaus der Vorrichtung 700 und ihrer physikalischen Wirkungsweise handelt es sich um einen extrem breitbandigen Empfänger, der insbesondere für die Ultrawideband-Kommunikation verwendet werden kann. Der Hochpassfilter 702 kann bevorzugt als Messverstärker ausgebildet sein.

Neben der Analyse der gezielten Modulationen durch ein elektromagnetisches Wechselfeld 706 kann diese Vorrichtung 700 auch für die Analyse des elektromagnetischen Strahlungsspektrums oder von Teilen des elektromagnetischen Strahlungsspektrums am Ort des NV-Zentrums 26 verwendet werden.

Die Analyse des Nutzsignals 708 kann - wie für den Fachmann geläufig - die Demodulation beispielsweise mit Mischern und Filtern beinhalten. Hier sei beispielhaft auf M. Bossert "Nachrichtenübertragung" Vieweg+Teubner Verlag; Auflage: 5., durchges. u. erg. Aufl. 2011 (4. August 2011), A. Mertins "Signaltheorie: Grundlagen der Signalbeschreibung, Filterbänke, Wavelets, Zeit-Frequenz-Analyse, Parameter- und Signalschätzung" Springer Vieweg; Auflage: 3., überarb. u. erw. Aufl. 2013 (8. Dezember 2012) sowie Lüke "Signalübertragung: Grundlagen der digitalen und analogen Nachrichtenübertragungssysteme", Springer Vieweg; Auflage: 12 (19. Februar 2015) verwiesen.

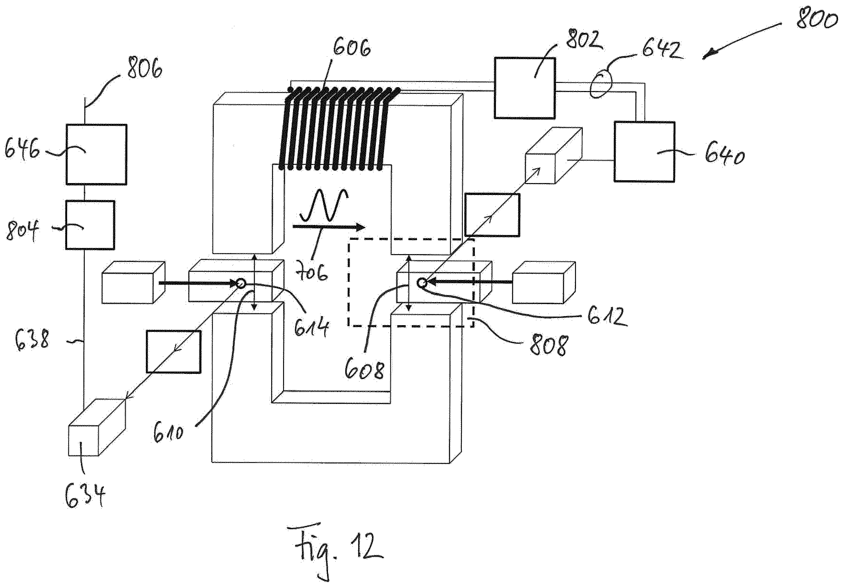

Fig. 12 zeigt eine achte bevorzugte Ausgestaltung der erfindungsgemäßen Vorrichtung 800.

Es ist zu erkennen, dass diese Vorrichtung, die eine Alternative zur Vorrichtung 700 nach Fig. 11 darstellt, grundsätzlich von der Vorrichtung 600 nach Fig. 9 ausgeht, wobei hier entsprechend der Vorrichtung 700 nach Fig. 11 der Regler 640 eine Tiefpasscharakteristik aufweist bzw. optional ein gesonderter Tiefpassfilter 802 mit einer oberen Grenzfrequenz $f_{go}$ für die Transmission besteht, der das Regelsignal 642 filtert. Außerdem wird das Erfassungssignal 638 des Fotodetektors 634 mit dem Hochpassfilter 804, der eine untere Grenzfrequenz $f_{gu}$ für die Transmission aufweist, gefiltert und dem Messverstärker 646 zugeführt, der ein entsprechendes Nutzsignal 806 ausgibt. Weiterhin besteht eine magnetische Schirmung 808, beispielsweise aus einem weich-magnetischem Material, die Einflüsse der elektromagnetischen Strahlung 706 bzw. eines elektromagnetischen Hintergrunds auf das NV-Zentrum 612 im Luftspalt 608 verhindern.

Durch die magnetische Schirmung 808 ist die magnetische Flussdichte B im Luftspalt 608 unabhängig von externen elektromagnetischen Einflüssen 706. Das erste NV-Zentrum 612 dient somit als Referenzzentrum für die Regelung der magnetischen Feldstärke H mittels der Spule 606 über den Regler 640.

Nur das zweite NV-Zentrum 614 im Luftspalt 610 reagiert auf das elektromagnetische Feld 706, so dass dessen hochfrequente Anteile mittels des Hochpassfilters 804 analysiert werden können.

Mit dieser Vorrichtung 800 kann somit eine noch exaktere und stabilere Informationsübertragung bzw. Analyse auf elektromagnetische Hintergrundfelder erfolgen.

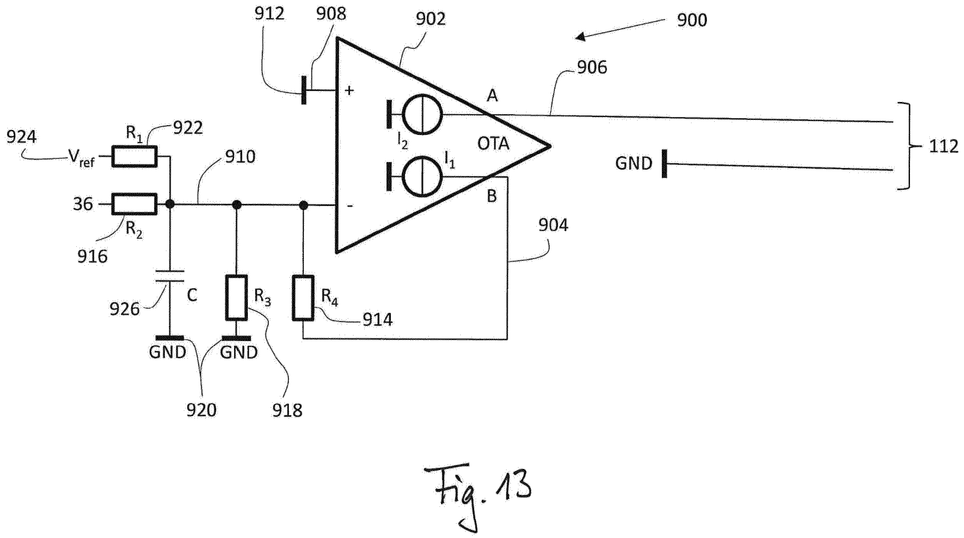

In Fig. 13 ist ein Beispiel für einen PI-Regler 900 gezeigt, der als Regler 38, 88, 640, 646, 702 in jeder der erfindungsgemäßen Vorrichtungen 10, 50, 100, 200, 300, 400, 500, 600, 700 verwendet werden kann.

Es ist zu erkennen, dass dieser PI-Regler 900 als Kernstück einen Transkonduktanzverstärker (OTA) 902 aufweist. Der hier gezeigte OTA 902 besitzt zwei Ausgänge 904, 906, die durch seine zwei Ausgangsstromquellen I1 und I2 gebildet werden. Die beiden Stromquellen (I1) 904 und (I2) 906 sind miteinander verkoppelt, und erzeugen jeweils einen Ausgangsstrom, der mit einer jeweiligen Proportionalitätskonstante proportional zur Differenz der Eingangsspannungen am positiven Eingang (+) 908 minus dem negativen Eingang (-) 910 sind. Der positive Eingang (+) 908 ist mit einem Bezugspotenzial 912 verbunden. Der Ausgangsstrom der ersten Ausgangstromquelle 904 (I1) des OTA 902 wird über den optionalen vierten Widerstand (R4) 914 in den Knoten des negativen Eingangs 910 (-) des OTA 902 eingespeist. Der optionale Widerstand (R4) 914 kann ggf. auch überbrückt sein und dann fehlen. Der Photodetektor 34 speist über den Anschluss 36 und den Widerstand (R2) 916 sein Spannungsausgangssignal ein. Diese beiden Ströme werden über den Arbeitswiderstand (R3) 918, der gegen das Bezugspotenzial (GND) 920 geschaltet ist, in die Eingangsspannung für den negativen Eingang (-) 910 des OTA 902 verwandelt. Für einen geeigneten Startpunkt der Regelung wird über den ersten Widerstand (R1) 922 in diesem Beispiel ein Offset-Strom aus einer Referenzspannung (Vref) 924 eingespeist. Der Kondensator (C) 926 sorgt für eine Tiefpass-Charakteristik des Reglers, der sich bei tiefen Frequenzen dann wie ein PI-Regler verhält. Die Rückleitung der magnetfelderregenden Spule 108 ist hier mit dem Bezugspotenzial (GND) 920 verbunden.

Zu beachten ist, dass der PI-Regler 900 keine Strombegrenzung aufweist, was zu einem Überlaufen des Lumineszenzminimums führen würde. Daher müsste für eine solche Begrenzung (nicht gezeigt, aber dem Fachmann geläufig) gesorgt werden.

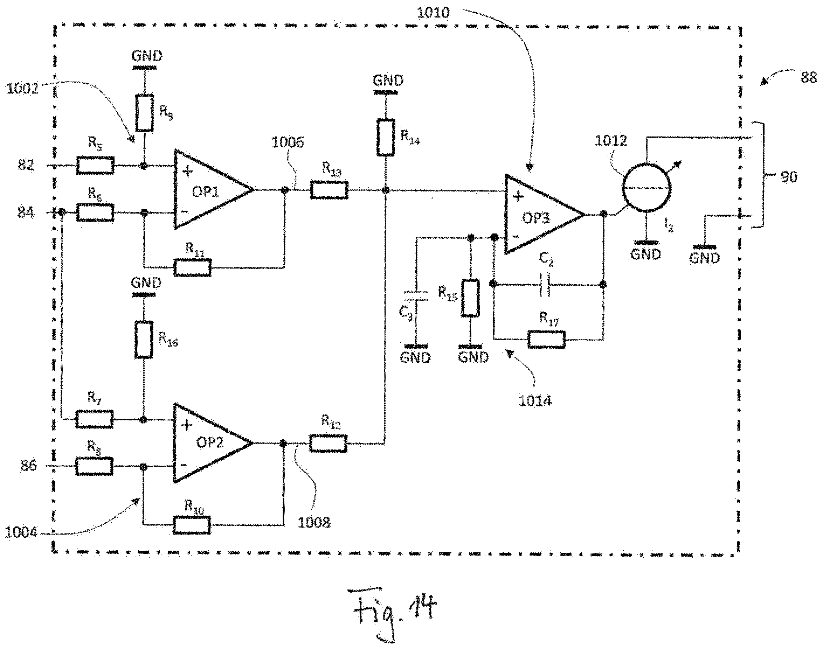

In Fig. 14 ist ein Regler 88 zum Einsatz in der erfindungsgemäßen Vorrichtung nach Fig. 3 gezeigt.

Es ist zu erkennen, dass aus den drei Messsignalen 82, 84, 86 der drei Photodetektoren 76, 78, 80 mittels der beiden Subtraktionsschaltungen 1002 (Widerstände R5, R4, R1, R11 und Operationsverstärker OP1) sowie 1004 (Widerstände R7, R8, R16, R10 und Operationsverstärker OP2) zwei Gradientensignale 1006, 1008 gebildet werden. Mittels der nachfolgenden Additionsstufe 1010 (R13, R12, R14, Operationsverstärker OP3) wird nun ein Summensignal gebildet, dass zur Steuerung der zweiten Stromquelle (I2) 1012 verwendet wird, die das Regelsignal 90 für die Spule 94 speist. Das Rückkoppelnetzwerk 1014 (R17, R15, C2, C3) dient hier zur Realisierung einer PID-Charakteristik.

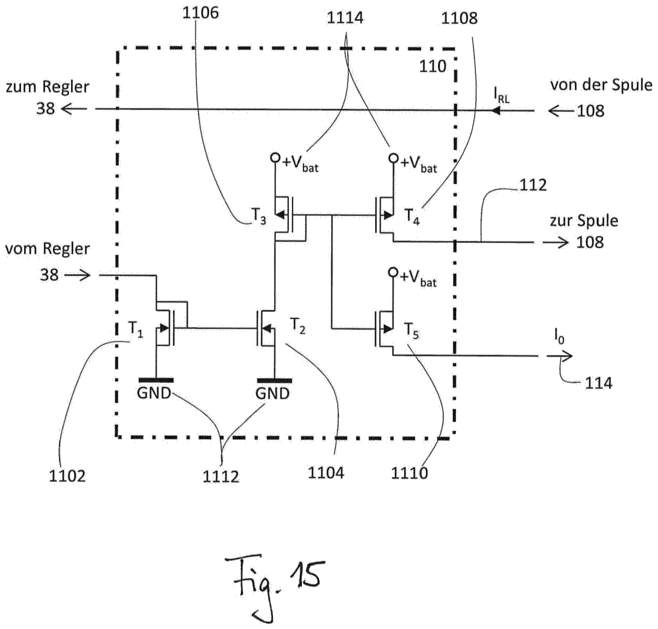

In Fig. 15 ist schließlich eine bevorzugte Ausführungsform der Stromspiegelanordnung 110, beispielsweise zur Verwendung in einer der erfindungsgemäßen Vorrichtungen nach den Fig. 4, 5 oder 7 gezeigt.

Es ist zu erkennen, dass die Stromspiegelanordnung 110 einen ersten MOS-Transistor (T1) 1102 aufweist, der als MOS-Diode verschaltet ist. Der erste MOS-Transistor (T1) 1102 erfasst den vom Regler 38 kommenden Strom und erzeugt ein Referenzsignal, mit dem der zweite Transistor (T2) 1104 an seiner Steuerelektrode angesteuert wird. Der zweite Transistor (T2) 1104 arbeitet dabei als Stromquelle für den Querstrom durch den dritten Transistor (T3) 1106. Dieser Querstrom wird, wie für Stromspiegel beispielsweise aus Tietze, Schenk, "Halbleiter-Schaltungstechnik", Springer bekannt ist, durch das Verhältnis der Transistoren (T1) 1102 zu (T2) 1104 bestimmt. Bei den Transistoren (T1) 1102 und (T2) 1104 handelt es sich in diesem Beispiel bevorzugt um N-Kanal-Transistoren. Der dritte Transistor (T3) 1106 erfasst den durch den zweiten Transistor (T2) 1104 erzeugten Querstrom und ist wieder als MOS-Diode verschaltet. Er ist bevorzugt ein P-Kanal-Transistor. Er erzeugt eine interne Referenzspannung, von deren Wert die durch die beiden Stromquellen-Transistoren (T4) 1108 und (T5) 1110 erzeugten Ströme abhängen. Hierbei liefert in dem Beispiel der vierte Transistor (T4) 1108 den Strom 112 für die Ansteuerung der magnetfelderzeugenden Spule 108. Der fünfte Transistor (T5) 1110 liefert in diesem Beispiel den Referenzstrom (I0) 114, der dann an anderer Stelle in nachfolgenden Schaltungen 100, 200, 400 verwendet werden kann.

Die Transistoren (T3) 1106, (T4) 1108 und (T5) 1110 sind in diesem Beispiel bevorzugt P-Kanal-Transistoren. Der vom Regler 38 kommende Eingangsstrom durch den Transistor (T1) 1102 gegen Masse (GND) 1112 steht in einem festen Verhältnis zu dem Querstrom von der Versorgungsspannung (Vbat) 1114 durch den dritten Transistor (T3) 1106 und den zweiten Transistor (T2) 1104 nach Masse (GND) 1112, das durch das Verhältnis der Transistoren (T1) 1102 zu (T2) 1104 festgelegt ist. Der Strom von der Versorgungsspannung (Vbat) 1114 zur Spule 108, durch die Spule 108 nach Masse (GND) 1112 hängt von der Größe des Querstroms entsprechend dem Verhältnis der Transistoren (T3) 1006 zu (T4) 1108 ab und ist damit direkt proportional vom Eingangsstrom durch den Transistor (T1) 1102. Der erzeugte Referenzstrom (I0) 114 von der Versorgungsspannung (Vbat) 1114 zur nachfolgenden Schaltung 100, 200, 400 und von dort nach Masse (GND) 1112 hängt von der Größe des Querstroms entsprechend dem Verhältnis der Transistoren (T3) 1106 zu (T5) 1108 und damit direkt proportional vom Eingangsstrom durch den Transistor (T1) 1102 ab. Außerdem sind offensichtlich dann der Strom 112 zur Spule 108 und der Referenzstrom (I0) 114 direkt proportional zueinander.

Auch wenn die Erfindung im Rahmen der Fig. 2 bis 15 stets im Zusammenhang mit einer elektromagnetischen Anregung mittels einer LASER-Diode und der Verwendung von Fotodetektoren für die Fluoreszenz beschrieben wurde, ist dies nicht zwingend. Tatsächlich können auch andere Anregungen, insbesondere elektrische Anregungen, beispielsweise durch heiße Ladungsträger im umgebenden Material eines Farbzentrums, und/oder durch Anregung ein Auslesen, bevorzugt elektronisches Auslesen, des Photostroms vorgenommen werden. Da die Lumineszenz eng mit dem Photostrom verbunden ist, gelten auch hier die vorstehend beschriebenen Vorteile. Außerdem könnten anstelle den bevorzugt verwendeten LASER-Dioden 28, 616, 618 auch LEDs oder andere geeignete Leuchtmittel eingesetzt werden.

Auch wenn vorstehend jeweils von einem einzelnen NV-Zentrum im Material die Rede ist, so können auch Ensembles von NV-Zentren im Material eingesetzt werden. Für ein NV-Zentrum erreicht man eine sehr gut Ortsauflösung, die bei Verwendung von NV-Zentren etwas reduziert ist. Allerdings nimmt die Signalstärke bei Verwendung von NV-Ensembles zu.

Aus der vorstehenden Darstellung ist deutlich geworden, dass mit der vorliegenden Erfindung eine Vorrichtung 10, 50, 100, 200, 300, 400, 500, 600, 700, 800 und ein Verfahren zur Erzeugung und Regelung einer magnetischen Feldstärke H bereitgestellt werden, wobei die Erzeugung sehr stabil und präzise erfolgt. Bevorzugt können Referenzwerte physikalischer Größe relativ einfach und kostengünstig erzeugt werden. Außerdem können magnetische Flussdichten mit hoher Auflösung und insbesondere sehr robust vermessen werden. Die Erfindung kann auch zur Informationsübertragung, insbesondere zur Ultrawideband-Kommunikation, verwendet werden. Die notwendigen Vorrichtungen 10, 50, 100, 200, 300, 400, 500, 600, 700, 800 können dabei sehr klein, insbesondere miniaturisiert, und mobil benutzbar ausgebildet werden.

Außerdem können gegenständliche Merkmale der Vorrichtung umformuliert auch als Verfahrensmerkmale Verwendung finden und Verfahrensmerkmale umformuliert als gegenständliche Merkmale der Vorrichtung. Eine solche Umformulierung ist somit automatisch mit offenbart.

## Bezugszeichenliste

| | |
|---|---|
| 10 | elektrischer Regelkreis des Grundprinzips der vorliegenden Erfindung |
| 12 | magnetischer Teilkreis |
| 14 | Jochanordnung |
| 16, 18 | Kerne der Jochanordnung 14 |
| 20 | Luftspalt |
| 22 | Spule |
| 24 | erstes Material, Diamant vom Typ Ib |
| 26 | NV-Zentrum im ersten Material, Diamant 24 |
| 28 | LASER-Diode |
| 30 | elektromagnetische Strahlung erster Wellenlänge der LASER-Diode 28 |
| 32 | emittierte elektromagnetische Strahlung zweiter Wellenlänge des NV-Zentrums 26 |
| 34 | Fotodetektor |
| 35 | optischer Filter |
| 36 | Erfassungssignal des Fotodetektors 34 |
| 38 | Regler |
| 40 | Regelsignal des Reglers 38 zur Ansteuerung der Spule 22 |
| 42 | elektrischer Leiter |
| 50 | alternative Ausgestaltung des erfindungsgemäßen Regelkreises |
| 52 | Luftspalt |
| 54 | Jochanordnung |
| 56, 58, 60 | parallel angeordnete Magnetbereiche am Luftspalt 52 |
| 62, 64, 66 | NV-Zentren |
| 68, 70, 72 | elektromagnetische Strahlungen einer zweiten Wellenlänge |
| 74 | Filter |
| 76, 78, 80 | Fotodetektoren |
| 82, 84, 86 | Erfassungssignale der Fotodetektoren 76, 78, 80 |
| 88 | Reglers |
| 90 | Regelsignal des Reglers 88 |
| 92 | elektrischer Leiter |
| 94 | Spule |
| 100 | erste bevorzugte Ausgestaltung der erfindungsgemäßen Vorrichtung |
| 102 | magnetischer Kreis |
| 104 | durchgehendes magnetisches Joch |
| 106 | Luftspalt |
| 108 | Spule |
| 110 | Stromspiegel |
| 112 | Regelsignal |
| 114 | Ausgangsstrom ($I_0$) |
| 200 | zweite bevorzugte Ausgestaltung der erfindungsgemäßen Vorrichtung |
| 202 | Widerstand, Quellenwiderstand (Rq) |
| 204 | Referenzspannung ($V_0$) |
| 300 | dritte bevorzugte Ausgestaltung der erfindungsgemäßen Vorrichtung |
| 302 | Kern |

| | |
|---|---|
| 304 | Spule |
| 306 | zweiter magnetischer Kreis |
| 400 | vierte bevorzugte Ausgestaltung der erfindungsgemäßen Vorrichtung |
| 402 | Kondensator |
| 404, 406 | Kondensatorplatten |
| 500 | fünfte bevorzugte Ausgestaltung der erfindungsgemäßen Vorrichtung |
| 502 | magnetischer Kreis |
| 504, 506 | zusätzliche Elemente zum Einleiten eines externen magnetischen Feldes |
| 600 | sechste bevorzugte Ausgestaltung der erfindungsgemäßen Vorrichtung |
| 602 | magnetischer Kreis |
| 604 | Jochanordnung |
| 606 | Spule |
| 608, 610 | Luftspalte der Jochanordnung |
| 611a | erstes Material, Diamant |
| 611b | weiteres Material, Diamant |
| 612, 614 | NV-Zentren |
| 616, 618 | LASER-Dioden |
| 620, 622 | elektromagnetischer Strahlung einer ersten Wellenlänge |
| 624, 626 | von den NV-Zentren 612, 614 emittierte elektromagnetische Strahlung einer zweiten Wellenlänge |
| 628, 630 | Filter |
| 632, 634 | Fotodetektoren |
| 636, 638 | Erfassungssignal der Fotodetektoren 632, 634 |
| 640 | Regler |
| 642 | Regelsignal |
| 644 | elektrischer Leiter |
| 646 | Messverstärker |
| 648 | Messsignal |
| 650 | planares Substrat |
| 700 | siebente bevorzugte Ausgestaltung der erfindungsgemäßen Vorrichtung |
| 702 | Hochpassfilter mit einer unteren Grenzfrequenz $f_{gu}$ für die Transmission |
| 704 | Tiefpassfilter mit einer oberen Grenzfrequenz $f_{go}$ für die Transmission |
| 706 | elektromagnetisches Wechselfeld |
| 708 | Nutzsignal |
| 800 | achte bevorzugte Ausgestaltung der erfindungsgemäßen Vorrichtung |
| 802 | Tiefpassfilter mit einer oberen Grenzfrequenz $f_{go}$ für die Transmission |
| 804 | Hochpassfilter mit einer unteren Grenzfrequenz $f_{gu}$ für die Transmission |
| 806 | Nutzsignal |
| 808 | magnetische Schirmung |
| 900 | PI-Regler zur Verwendung als Regler 38, 88, 640, 646, 702 |
| 902 | Transkonduktanzverstärker (OTA) |
| 904, 906 | Ausgänge |
| 904 | Stromquelle (I1) |
| 906 | Stromquelle (I2) |
| 908 | positiver Eingang (+) |
| 910 | negativer Eingang (-) |
| 912 | Bezugspotenzial |
| 914 | optionaler vierter Widerstand (R4) |
| 916 | Widerstand (R2) |
| 918 | Arbeitswiderstand (R3) |
| 920 | Bezugspotenzial (GND) |
| 922 | erster Widerstand (R1) |
| 924 | Referenzspannung (Vref) |
| 926 | Kondensator (C) |
| 1000 | Subtraktionsschaltung (Widerstände R5, R4, R1, R11 und Operationsverstärker OP1) |
| 1004 | Subtraktionsschaltung (Widerstände R7, R8, R16, R10 und Operationsverstärker OP2) |
| 1006, 1008 | Gradientensignale |
| 1010 | Additionsstufe (R13, R12, R14, Operationsverstärker OP3) |
| 1012 | zweite Stromquelle (I2) |

| 1014 | Rückkoppelnetzwerk (R17, R15, C2, C3) |
| 1102 | erster MOS-Transistor (T1) |
| 1104 | zweiter Transistor (T2) |
| 1106 | dritter Transistor (T3) |
| 1108 | Stromquellen-Transistor (T4) |
| 1110 | Stromquellen-Transistor (T5) |
| 1112 | Masse (GND) |
| 1114 | Versorgungsspannung (Vbat) |

## Patentansprüche

1. Vorrichtung (10; 50; 100; 200; 300; 400; 500; 700; 800) zur Erzeugung und Regelung einer magnetischen Feldstärke, mit

   - einem ersten Material (24; 611a), das bei einer physikalischen Anregung eine Lumineszenz und/oder einen Photostrom erzeugt, wobei die Luminszenz bzw. der Photostrom in Bezug auf ein magnetisches Feld bei zumindest einer magnetischen Flussdichte eine Resonanzstelle aufweist,
   - Mitteln (28; 616, 618) zur Erzeugung der physikalischen Anregung,
   - Mitteln (12, 16, 18, 20, 22; 52, 54; 102, 104, 106, 108; 304, 306; 502; 604, 606, 608) zur Magnetfelderzeugung, wobei das erste Material (24; 611a) dem erzeugten Magnetfeld ausgesetzt ist, wobei die magnetische Feldstärke einstellbar ist, und
   - Mitteln (34; 76, 78, 80; 632) zur Messung der Lumineszenz bzw. des Photostroms mit einem Erfassungssignal (36; 82, 84, 86; 636), das die Stärke des erfassten Lumineszenzsignals bzw. Photostromsignals wiedergibt, die Vorrichtung **gekennzeichnet durch**
   - Mittel (38; 88; 640) zur Regelung, die angepasst sind, ein Regelsignal (40; 90; 112; 642) für die Regelung der Mittel (12, 16, 18, 20, 22; 52, 54; 102, 104, 106, 108; 304, 306; 502; 602, 604, 606, 608) zur Magnetfelderzeugung auszugeben und die magnetischen Feldstärke in Abhängigkeit vom Erfassungssignal (36; 82, 84, 86; 636) so zu regeln, dass das Erfassungssignal (36; 82, 84, 86; 636) einen Resonanzextremwert annimmt.

2. Vorrichtung (100; 200; 300; 400) nach Anspruch 1, **gekennzeichnet durch** Mittel (110; 110, 202; 302, 304; 110; 202, 402) zur Erzeugung einer physikalischen Größe in Abhängigkeit vom Regelsignal (112), wobei die physikalische Größe (110; 110, 202; 302, 304; 110; 202, 402) bevorzugt eine Größe aus der Gruppe umfassend elektrischer Strom, elektrische Spannung, magnetisches Feld, elektrisches Feld, Zeit und Frequenz ist, wobei die Mittel (110; 110, 202; 302, 304; 110; 202, 402) zur Erzeugung der physikalischen Größe insbesondere zumindest ein Element aus der Gruppe: Stromspiegel (110), Widerstand (202), Spule (304), Kondensator (402), Transkonduktanzverstärker und Operationsverstärker umfassen.

3. Vorrichtung (600; 800) nach einem der vorherigen Ansprüche, **dadurch gekennzeichnet, dass** weiterhin bestehen:

   - mindestens ein weiteres ein Material (611b), das bei einer weiteren physikalischen Anregung eine Lumineszenz und/oder einen Photostrom erzeugt, wobei die Luminszenz bzw. der Photostrom in Bezug auf ein magnetisches Feld bei zumindest einer magnetischen Flussdichte einen Extremwert aufweist,
   - weitere Mittel (618) zur Erzeugung der weiteren physikalischen Anregung,
   - weitere Mittel (604, 606, 610) zur Magnetfelderzeugung, wobei das weitere Material (611b) dem erzeugten Magnetfeld ausgesetzt ist, wobei die magnetische Feldstärke einstellbar ist, wobei die weiteren Mittel (604, 606, 610) zur Magnetfelderzeugung angepasst sind, das weitere Material (611b) demselben oder einem anderen Magnetfeld auszusetzen wie das erste Material (611a),
   - weitere Mittel (634) zur Messung der Lumineszenz bzw. des Photostroms des weiteren Materials (611b) mit einem weiteren Erfassungssignal (638), das die Stärke des erfassten weiteren Lumineszenzsignals bzw. des weiteren Photostromsignals wiedergibt.

4. Vorrichtung (10; 50; 100; 200; 300; 400; 500; 700; 800) nach einem der vorherigen Ansprüche, **dadurch gekennzeichnet,**
   **dass** das erste Material (24; 611a) bzw. das weitere Material (611b) eine Kristallstruktur aufweist mit zumindest einer Fehlstelle (26; 612, 614), wobei das erste Material (24; 611a) bzw. das weitere Material (611b) bevorzugt Diamant, Siliziumkarbid oder Silizium ist und die Fehlstelle ein Farbzentrum, insbesondere ein Stickstofffehlstellenzentrum oder ein Stickstofffehlstellenzentrum in Verbindung mit einem Europiumfehlstellenzentrum, einem Vanadiumfehlstellenzentrum oder einem Manganfehlstellenzentrum ist und/oder **dass** die Mittel (28; 616, 618) zur Erzeugung der physikalischen Anregung bzw. die weiteren Mittel (618) zur Erzeugung der physikalischen Anregung eine elektrische oder elektromagnetische Anregung, bevorzugt eine Anregung im optischen Bereich und/oder im Mikrowellenbereich, insbesondere eine LASER-Anregung oder eine LED-Anregung, oder eine Anregung durch ionisierende Strahlung, bereitstellen und/oder **dass** die Mittel (12, 16, 18, 20, 22; 52, 54; 102, 104, 106, 108; 304, 306; 502; 604, 606, 608) zur Magnetfelderzeugung bzw. die weiteren Mittel (604, 606, 610) zur Magnetfelderzeugung zumindest eine Spule (22; 94; 108; 606) umfassen, die durch einen Strom anregbar ist, wobei bevorzugt ein magnetischer Leiter, insbesondere in Form eines Jochs (14; 54; 104; 604) mit einem Luftspalt (20; 52; 106; 608, 610) besteht, wobei das erste Material (24; 611a) und/oder das weitere Material (611b) im Luftspalt (20; 52; 106; 608, 610) angeordnet ist.

5. Vorrichtung (10; 50; 100; 200; 300; 400; 500; 700; 800) nach einem der vorherigen Ansprüche, **dadurch gekennzeichnet, dass** die Mittel (34; 76, 78, 80; 632) zur Messung der Lumineszenz und/oder die weiteren Mittel (634) zur Messung der Lumineszenz einen Fotodetektor umfassen und bevorzugt einen Filter (35; 74), der die physikalische Anregung dämpft und/oder

   **dass** die Mittel zur Messung des Photostroms und/oder die weiteren Mittel zur Messung des Photostroms so ausgebildet sind, das eine Spannung zwischen zwei elektrischen Kontakten auf dem ersten Material bzw. dem weiteren Material angelegt und der Photostrom in Serie gemessen wird und/oder
   **dass** die Mittel zur Regelung (38; 88; 640) als stetiger linearer Regler, bevorzugt als PI- oder PID-Regler, ausgebildet sind.

6. Vorrichtung (700; 800) nach einem der vorherigen Ansprüche, **dadurch gekennzeichnet, dass** zumindest ein Hochpassfilter (704; 804) zur Filterung des Erfassungssignals (36) und/oder des weiteren Erfassungssignals (638) besteht und/der **dass** zumindest ein Tiefpassfilter (702; 802) zur Filterung des Regelsignals (40, 642) besteht.

7. Vorrichtung (700; 800) nach Anspruch 6, **dadurch gekennzeichnet, dass** der Betrag der unteren Grenzfrequenz des Hochpassfilters (704; 804) bevorzugt größer ist als der Betrag der oberen Grenzfrequenz des Tiefpassfilters (702; 802) bzw. der Mittel zur Regelung (38; 640).

8. Vorrichtung (50) nach einem der vorherigen Ansprüche, **dadurch gekennzeichnet, dass** die Mittel (52, 54, 56, 58, 60) zur Magnetfelderzeugung zumindest zwei, bevorzugt drei Magnetbereiche (56, 58, 60) aufweisen, die unterschiedliche magnetische Widerstände aufweisen, so dass zumindest zwei, bevorzugt drei Materialbereiche (62, 64, 66) des ersten Materials (24) bzw. des weiteren Materials unterschiedlichen Magnetfeldern ausgesetzt sind, wobei jedem Materialbereich (62, 64, 66) eigene Mittel (76, 78, 80) zur Messung der Lumineszenz bzw. des Photostroms mit einem jeweiligen Erfassungssignal (82, 84, 86), das die Stärke des erfassten Lumineszenzsignals bzw. Photostromsignals wiedergibt, zugeordnet sind, wobei die Mittel (88) zur Regelung angepasst sind, ein Regelsignal (90) für die Regelung der Mittel (54, 94) zur Magnetfelderzeugung auszugeben und die magnetischen Feldstärke in Abhängigkeit vom Erfassungssignal (82, 84, 86) so zu regeln, dass das Erfassungssignal (82, 84, 86) eines Materialbereichs (62, 64, 66) einen Extremwert annimmt.

9. Vorrichtung (800; 500) nach einem der vorherigen Ansprüche, **dadurch gekennzeichnet,**

   **dass** die Mittel (602, 604, 606, 608) zur Magnetfelderzeugung und/oder die weiteren Mittel zur Magnetfelderzeugung eine magnetische Schirmung (808) gegen äußere magnetische Felder aufweisen und/oder
   **dass** die Mittel (108, 502, 504) zur Magnetfelderzeugung angepasst sind, ein externes Magnetfeld dem Material (24) zuzuführen.

10. Vorrichtung (700; 800) nach einem der vorherigen Ansprüche, **dadurch gekennzeichnet, dass** die Mittel zur Erzeugung der physikalischen Anregung angepasst sind, eine Modulation der physikalischen Anregung vorzunehmen, wobei Mittel zur Korrelation der Modulation der physikalischen Anregung mit dem Erfassungssignal bestehen.

11. Verfahren zur Erzeugung und Regelung einer magnetischen Feldstärke, mit der Verwendung:

    - eines ersten Materials (24; 611a), das bei einer physikalischen Anregung eine Lumineszenz und/oder einen Photostrom erzeugt, wobei die Luminszenz bzw. der Photostrom in Bezug auf ein magnetisches Feld bei zumindest einer magnetischen Flussdichte eine Resonszstelle aufweist,
    - von Mitteln (28; 616, 618) zur Erzeugung der physikalischen Anregung, und

- von Mitteln (12, 16, 18, 20, 22; 52, 54; 102, 104, 106, 108; 304, 306; 502; 604, 606, 608) zur Magnetfelderzeugung, wobei das erste Material (24; 611a) dem erzeugten Magnetfeld ausgesetzt ist, wobei die magnetische Feldstärke einstellbar ist, das Verfahren **gekennzeichnet durch** die Verwendung
- von Mitteln (34; 76, 78, 80; 632) zur Messung der Lumineszenz bzw. des Photostroms mit einem Erfassungssignal (36; 82, 84, 86; 636), das die Stärke des erfassten Lumineszenzsignals bzw. des Photostromsignals wiedergibt,

wobei ein Regelsignal (40; 90; 112; 642) für die Regelung der Mittel (12, 16, 18, 20, 22; 52, 54; 102, 104, 106, 108; 304, 306; 502; 602, 604, 606, 608) zur Magnetfelderzeugung ausgegeben wird, um die magnetische Feldstärke in Abhängigkeit vom Erfassungssignal (36; 82, 84, 86; 636) so zu regeln, dass das Erfassungssignal (36; 82, 84, 86; 636) einen Resonanzextremwert annimmt.

**12.** Verfahren nach Anspruch 11, **dadurch gekennzeichnet, dass** die Vorrichtung (10; 50; 100; 200; 300; 400; 500; 700; 800) nach einem der Ansprüche 1 bis 10 verwendet wird.

**Claims**

**1.** Device (10; 50; 100; 200; 300; 400; 500; 700; 800) for generating and controlling a magnetic field intensity, comprising

- a first material (24; 611a) which, upon physical excitation, generates luminescence and/or photocurrent, wherein the luminescence or photocurrent exhibits a resonance point with respect to a magnetic field at at least one magnetic flux density,
- means (28; 616, 618) for generating the physical excitation,
- means (12, 16, 18, 20, 22; 52, 54; 102, 104, 106, 108; 304, 306; 502; 604, 606, 608) for generating a magnetic field, wherein the first material (24; 611a) is exposed to the generated magnetic field, wherein the intensity of the magnetic field is adjustable, and
- means (34; 76, 78, 80; 632) for measuring luminescence or photocurrent with a detection signal (36; 82, 84, 86; 636) which represents the intensity of the detected luminescence signal or photocurrent signal, wherein the device is **characterized by**
- control means (38; 88; 640) which are adapted to provide a control signal (40; 90; 112; 642) for controlling the means (12, 16, 18, 20, 22; 52, 54; 102, 104, 106, 108; 304, 306; 502; 602, 604, 606, 608) for generating a magnetic field and for controlling the magnetic field intensity as a function of the detection signal (36; 82, 84, 86; 636) so that the detection signal (36; 82, 84, 86; 636) takes a resonance extreme value.

**2.** Device (100; 200; 300; 400) according to claim 1, **characterized by** means (110; 110, 202; 302, 304; 110; 202, 402) for generating a physical variable as a function of the control signal (112), wherein the physical variable (110; 110, 202; 302, 304; 110; 202, 402) is preferably a variable from the group comprising electric current, electric voltage, magnetic field, electric field, time and frequency, wherein the means (110; 110, 202; 302, 304; 110; 202, 402) for generating the physical variable comprise in particular at least one element from the group: current mirror (110), resistor (202), coil (304), capacitor (402), transconductance amplifier and operational amplifier.

**3.** Device (600; 800) according to any one of the preceding claims, **characterized in that** there are additionally:

- at least one further material (611b) which, upon further physical excitation, generates luminescence and/or photocurrent, wherein the luminescence or photocurrent has an extreme value with respect to a magnetic field with at least one magnetic flux density,
- further means (618) for generating the further physical excitation,
- further means (604, 606, 610) for generating a magnetic field, wherein the further material (611b) is exposed to the generated magnetic field, wherein the intensity of the magnetic field is adjustable, wherein the further means (604, 606, 610) for generating a magnetic field is adapted to expose the further material (611b) to the same or another magnetic field as the first material (611a),
- further means (634) for measuring the luminescence or photocurrent of the further material (611b) with a further detection signal (638) representing the intensity of the detected further luminescence or photocurrent signal.

**4.** Device (10; 50; 100; 200; 300; 400; 500; 700; 800) according to any of the preceding claims, **characterized in**

**that** the first material (24; 611a) or the further material (611b) has a crystal structure with at least one defect (26; 612, 614), wherein the first material (24; 611a) or the further material (611b) preferably is diamond, silicon carbide or silicon, and the defect is a color center, in particular a nitrogen defect center or a nitrogen defect center in combination with a europium defect center, a vanadium defect center or a manganese defect center, and/or **that** the means (28; 616, 618) for generating the physical excitation or the further means (618) for generating the physical excitation provide electrical or electromagnetic excitation, preferably excitation in the optical and/or microwave range, in particular LASER excitation or LED excitation, or excitation by ionizing radiation, and/or

**that** the means (12, 16, 18, 20, 22; 52, 54; 102, 104, 106, 108; 304, 306; 502; 604, 606, 608) for generating a magnetic field or the further means (604, 606, 610) for generating a magnetic field comprise at least one coil (22; 94; 108; 606) which can be energized by a current, wherein preferably a magnetic conductor is provided, in particular in the form of a yoke (14; 54; 104; 604) with an air gap (20; 52; 106; 608, 610), wherein the first material (24; 611a) and/or the further material (611b) is arranged in the air gap (20; 52; 106; 608, 610).

5. Device (10; 50; 100; 200; 300; 400; 500; 700; 800) according to any one of the preceding claims, **characterized in that** the means (34; 76, 78, 80; 632) for measuring luminescence and/or the further means (634) for measuring luminescence comprise a photodetector and preferably a filter (35; 74) which dampens the physical excitation, and/or **that** the photocurrent measuring means and/or the further photocurrent measuring means are configured in such a way that a voltage is applied between two electrical contacts on the first material or the further material and the photocurrent is measured in series, and/or **that** the control means (38; 88; 640) are configured as a continuous linear controller, preferably as a PI or PID controller.

6. Device (700; 800) according to any of the preceding claims, **characterized in that** at least one high-pass filter (704; 804) is provided for filtering the detection signal (36) and/or the further detection signal (638) and/or **that** at least one low-pass filter (702; 802) is provided for filtering the control signal (40, 642).

7. Device (700; 800) according to claim 6, **characterized in that** the amount of the lower cut-off frequency of the high-pass filter (704; 804) is preferably greater than the amount of the upper cut-off frequency of the low-pass filter (702; 802) or of the control means (38; 640).

8. Device (50) according to any of the preceding claims, **characterized in that** the means (52, 54, 56, 58, 60) for generating a magnetic field comprise at least two, preferably three, magnetic zones (56, 58, 60) which have different magnetic resistances, so that at least two, preferably three material zones (62, 64, 66) of the one material (24) or the further material are exposed to different magnetic fields, wherein each material zone (62, 64, 66) is associated with its own means (76, 78, 80) for measuring luminescence or photocurrent with a respective detection signal (82, 84, 86) representing the intensity of the detected luminescence signal or photocurrent signal, wherein the control means (88) are configured to provide a control signal (90) for controlling the means (54, 94) and to control the magnetic field intensities as a function of the detection signal (82, 84, 86) so that the detection signal (82, 84, 86) of a material zone (62, 64, 66) takes an extreme value.

9. Device (800; 500) according to any one of the preceding claims, **characterized in**

**that** the means (602, 604, 606, 608) for generating a magnetic field and/or the further means for generating a magnetic field have a magnetic shield (808) against external magnetic fields and/or
**that** the means (108, 502, 504) for generating a magnetic field are configured to supply an external magnetic field to the material (24).

10. Device (700; 800) according to any of the preceding claims, **characterized in that** the means for generating the physical excitation are configured to perform a modulation of the physical excitation, wherein means for correlating the modulation of the physical excitation with the detection signal are provided.

11. Method for generating and controlling a magnetic field intensity, using:

- a first material (24; 611a) which, upon physical excitation, generates luminescence and/or photocurrent, wherein the luminescence or photocurrent exhibits a resonance point with respect to a magnetic field at at least one magnetic flux density,
- means (28; 616, 618) for generating the physical excitation, and
- means (12, 16, 18, 20, 22; 52, 54; 102, 104, 106, 108; 304, 306; 502; 604, 606, 608) for generating a magnetic field, wherein the first material (24; 611a) is exposed to the generated magnetic field, wherein the intensity of the magnetic field is adjustable, wherein the method is **characterized by** the use of

- means (34; 76, 78, 80; 632) for measuring luminescence or photocurrent with a detection signal (36; 82, 84, 86; 636) indicating the intensity of the detected luminescence or photocurrent signal,

wherein a control signal (40; 90; 112; 642) for controlling the means (12, 16, 18, 20, 22; 52, 54; 102, 104, 106, 108; 304, 306; 502; 602, 604, 606, 608) for generating a magnetic field is output in order to control the magnetic field intensity as a function of the detection signal (36; 82, 84, 86; 636) in such a way that the detection signal (36; 82, 84, 86; 636) takes a resonance extreme value.

12. Method according to claim 11, **characterized in that** the device (10; 50; 100; 200; 300; 400; 500; 700; 800) according to any one of claims 1 to 10 is used.

**Revendications**

1. Dispositif (10 ; 50 ; 100 ; 200 ; 300 ; 400 ; 500 ; 700 ; 800) pour la génération et la régulation d'une intensité de champ magnétique, avec

   - un premier matériau (24 ; 611a) qui, lors d'une excitation physique, génère une luminescence et/ou un photocourant, la luminescence ou le photocourant présentant un point de résonance par rapport à un champ magnétique à au moins une densité de flux magnétique,
   - des moyens (28 ; 616, 618) pour la génération de l'excitation physique,
   - des moyens (12, 16, 18, 20, 22 ; 52, 54 ; 102, 104, 106, 108 ; 304, 306 ; 502 ; 604, 606, 608) pour la génération d'un champ magnétique, le premier matériau (24 ; 611a) étant exposé au champ magnétique généré, l'intensité du champ magnétique étant réglable, et
   - des moyens (34 ; 76, 78, 80 ; 632) pour la mesure de la luminescence ou du photocourant avec un signal de détection (36 ; 82, 84, 86 ; 636) qui représente l'intensité du signal de luminescence ou du signal de photocourant détecté, le dispositif étant **caractérisé par**
   - des moyens (38 ; 88 ; 640) de régulation, qui sont adaptés pour fournir un signal de régulation (40 ; 90 ; 112 ; 642) pour la régulation des moyens (12, 16, 18, 20, 22 ; 52, 54 ; 102, 104, 106, 108 ; 304, 306 ; 502 ; 602, 604, 606, 608) pour la génération d'un champ magnétique et pour réguler l'intensité du champ magnétique en fonction du signal de détection (36 ; 82, 84, 86 ; 636) de telle sorte que le signal de détection (36 ; 82, 84, 86 ; 636) prenne une valeur extrême de résonance.

2. Dispositif (100 ; 200 ; 300 ; 400) selon la revendication 1, **caractérisé par** des moyens (110 ; 110, 202 ; 302, 304 ; 110 ; 202, 402) pour la génération d'une grandeur physique en fonction du signal de régulation (112), la grandeur physique (110 ; 110, 202 ; 302, 304 ; 110 ; 202, 402) étant de préférence une grandeur du groupe comprenant le courant électrique, la tension électrique, le champ magnétique, le champ électrique, le temps et la fréquence, les moyens (110 ; 110, 202 ; 302, 304 ; 110 ; 202, 402) pour la génération de la grandeur physique comprenant notamment au moins un élément du groupe : miroir de courant (110), résistance (202), bobine (304), condensateur (402), amplificateur de transconductance et amplificateur opérationnel.

3. Dispositif (600 ; 800) selon l'une quelconque des revendications précédentes, **caractérisé en ce qu'**il existe en outre :

   - au moins un autre matériau (611b) qui, lors d'une autre excitation physique, génère une luminescence et/ou un photocourant, la luminescence ou le photocourant présentant une valeur extrême par rapport à un champ magnétique à au moins une densité de flux magnétique,
   - d'autres moyens (618) pour la génération de l'autre excitation physique,
   - d'autres moyens (604, 606, 610) pour la génération d'un champ magnétique, l'autre matériau (611b) étant exposé au champ magnétique généré, l'intensité du champ magnétique étant réglable, les autres moyens (604, 606, 610) de génération d'un champ magnétique étant adaptés pour exposer l'autre matériau (611b) au même ou à un autre champ magnétique que le premier matériau (611a),
   - d'autres moyens (634) de mesure de la luminescence ou du photocourant de l'autre matériau (611b) avec un autre signal de détection (638) qui représente l'intensité de l'autre signal de luminescence ou de l'autre signal de photocourant détecté.

**4.** Dispositif (10 ; 50 ; 100 ; 200 ; 300 ; 400 ; 500 ; 700 ; 800) selon l'une quelconque des revendications précédentes, **caractérisé en ce que**

le premier matériau (24 ; 611a) ou l'autre matériau (611b) présente une structure cristalline avec au moins un défaut (26 ; 612, 614), le premier matériau (24 ; 611a) ou l'autre matériau (611b) étant de préférence du diamant, du carbure de silicium ou du silicium et le défaut étant un centre de couleur, notamment un centre de défaut d'azote ou un centre de défaut d'azote en combinaison avec un centre de défaut d'europium, un centre de défaut de vanadium ou un centre de défaut de manganèse et/ou

**en ce que** les moyens (28 ; 616, 618) de génération de l'excitation physique ou les autres moyens (618) de génération de l'excitation physique fournissent une excitation électrique ou électromagnétique, de préférence une excitation dans le domaine optique et/ou dans le domaine des micro-ondes, notamment une excitation LASER ou une excitation LED, ou une excitation par rayonnement ionisant, et/ou

**en ce que** les moyens (12, 16, 18, 20, 22 ; 52, 54 ; 102, 104, 106, 108 ; 304, 306 ; 502 ; 604, 606, 608) de génération d'un champ magnétique ou les autres moyens (604, 606, 610) de génération d'un champ magnétique comprennent au moins une bobine (22 ; 94 ; 108 ; 606) qui peut être excitée par un courant, il existant de préférence un conducteur magnétique, notamment sous la forme d'une culasse (14 ; 54 ; 104 ; 604) avec un entrefer (20 ; 52 ; 106 ; 608, 610), le premier matériau (24 ; 611a) et/ou l'autre matériau (611b) étant disposé dans l'entrefer (20 ; 52 ; 106 ; 608, 610).

**5.** Dispositif (10 ; 50 ; 100 ; 200 ; 300 ; 400 ; 500 ; 700 ; 800) selon l'une quelconque des revendications précédentes, **caractérisé en ce que** les moyens (34 ; 76, 78, 80 ; 632) de mesure de la luminescence et/ou les autres moyens (634) de mesure de la luminescence comprennent un photodétecteur et de préférence un filtre (35 ; 74) qui amortit l'excitation physique et/ou

**en ce que** les moyens de mesure du photocourant et/ou les autres moyens de mesure du photocourant sont conçus de telle sorte qu'une tension est appliquée entre deux contacts électriques sur le premier matériau ou l'autre matériau et le photocourant est mesuré en série et/ou

**en ce que** les moyens de régulation (38 ; 88 ; 640) sont conçus sous forme de régulateur linéaire continu, de préférence sous forme de régulateur PI ou PID.

**6.** Dispositif (700 ; 800) selon l'une quelconque des revendications précédentes, **caractérisé en ce qu'**il existe au moins un filtre passe-haut (704; 804) pour la filtration du signal de détection (36) et/ou de l'autre signal de détection (638) et/ou **en ce qu'**il existe au moins un filtre passe-bas (702 ; 802) pour la filtration du signal de régulation (40, 642).

**7.** Dispositif (700 ; 800) selon la revendication 6, **caractérisé en ce que** le montant de la fréquence de coupure inférieure du filtre passe-haut (704 ; 804) est de préférence supérieure au montant de la fréquence de coupure supérieure du filtre passe-bas (702 ; 802) ou des moyens de régulation (38 ; 640).

**8.** Dispositif (50) selon l'une quelconque des revendications précédentes, **caractérisé en ce que** les moyens (52, 54, 56, 58, 60) de génération d'un champ magnétique présentent au moins deux, de préférence trois zones magnétiques (56, 58, 60) qui présentent des résistances magnétiques différentes, de telle sorte qu'au moins deux, de préférence trois zones de matériau (62, 64, 66) du premier matériau (24) ou de l'autre matériau sont exposées à des champs magnétiques différents, chaque zone de matériau (62, 64, 66) étant associée à ses propres moyens (76, 78, 80) de mesure de la luminescence ou du photocourant avec un signal de détection respectif (82, 84, 86) qui représente l'intensité du signal de luminescence ou du signal de photocourant détecté, les moyens (88) de régulation étant adaptés pour fournir un signal de régulation (90) pour la régulation des moyens (54, 94) de génération d'un champ magnétique et pour réguler les intensités du champ magnétique en fonction du signal de détection (82, 84, 86) de telle sorte que le signal de détection (82, 84, 86) d'une zone de matériau (62, 64, 66) prenne une valeur extrême.

**9.** Dispositif (800 ; 500) selon l'une quelconque des revendications précédentes, **caractérisé en ce que** les moyens (602, 604, 606, 608) de génération d'un champ magnétique et/ou les autres moyens de génération d'un champ magnétique présentent un blindage magnétique (808) contre les champs magnétiques externes et/ou **en ce que** les moyens (108, 502, 504) de génération d'un champ magnétique sont adaptés pour amener un champ magnétique externe au matériau (24).

**10.** Dispositif (700 ; 800) selon l'une quelconque des revendications précédentes, **caractérisé en ce que** les moyens de génération de l'excitation physique sont adaptés pour effectuer une modulation de l'excitation physique, il existant des moyens de corrélation de la modulation de l'excitation physique avec le signal de détection.

**11.** Procédé de génération et de régulation d'une intensité de champ magnétique, avec l'utilisation :

- d'un premier matériau (24 ; 611a) qui, lors d'une excitation physique, génère une luminescence et/ou un photocourant, la luminescence ou le photocourant présentant un point de résonance par rapport à un champ magnétique à au moins une densité de flux magnétique,
- de moyens (28 ; 616, 618) de génération de l'excitation physique, et
- de moyens (12, 16, 18, 20, 22 ; 52, 54 ; 102, 104, 106, 108 ; 304, 306 ; 502 ; 604, 606, 608) de génération d'un champ magnétique, le premier matériau (24 ; 611a) étant exposé au champ magnétique généré, l'intensité du champ magnétique étant réglable, le procédé étant **caractérisé par** l'utilisation
- de moyens (34 ; 76, 78, 80 ; 632) pour la mesure de la luminescence ou du photocourant avec un signal de détection (36 ; 82, 84, 86 ; 636) qui représente l'intensité du signal de luminescence ou du signal de photocourant détecté,

un signal de régulation (40 ; 90 ; 112 ; 642) pour la régulation des moyens (12, 16, 18, 20, 22 ; 52, 54 ; 102, 104, 106, 108 ; 304, 306 ; 502 ; 602, 604, 606, 608) pour la génération d'un champ magnétique étant fourni afin de réguler l'intensité du champ magnétique en fonction du signal de détection (36 ; 82, 84, 86 ; 636) de telle sorte que le signal de détection (36 ; 82, 84, 86 ; 636) prenne une valeur extrême de résonance.

**12.** Procédé selon la revendication 11, **caractérisé en ce que** le dispositif (10 ; 50 ; 100 ; 200 ; 300 ; 400 ; 500 ; 700 ; 800) selon l'une quelconque des revendications 1 à 10 est utilisé.

Fig. 1a

Fig. 1b

Fig. 2

EP 3 874 343 B1

Fig. 3

Fig. 4

Fig. 5

Fig. 6

Fig. 7

Fig. 8

Fig. 9

EP 3 874 343 B1

Fig. 10

EP 3 874 343 B1

Fig. 11

EP 3 874 343 B1

Fig. 12

Fig. 13

Fig. 14

EP 3 874 343 B1

Fig. 15

**IN DER BESCHREIBUNG AUFGEFÜHRTE DOKUMENTE**

**In der Beschreibung aufgeführte Patentdokumente**

- DE 102015208151 A1
- DE 102017205099 A1
- WO 2018174912 A
- DE 4322830 A1
- DE 102010060527 B3
- DE 10000707 A1

**In der Beschreibung aufgeführte Nicht-Patentliteratur**

- **A. WICKENBROCK et al.** Microwave-free magnetometry with nitrogen-vacancy centers in diamond. *Appl. Phys. Lett.,* 2016, vol. 109, 053505
- **J. LEPPER.** Der Zusammenhang von Elektronenemission und Lumineszenzerscheinungen angeregter Kristalle. *Z. Naturforschg,* 1955, vol. 10a, 47-52
- **A. ZAITSEV.** Optical Properties of Diamond. Springer, 2001
- **B. BURCHARD.** Elektronische und optoelektronische Bauelemente und Bauelemente Grundstrukturen auf Diamantbasis. *Dissertation, Hagen,* 1994
- **B. TEGETMEYER et al.** Charge state modulation of nitrogen vacancy centers in diamond by applying a forward voltage across a p-i-n junction. *Diamond and Related Materials,* Mai 2016, vol. 65, 42-46
- **B. TEGETMEYER et al.** Electroluminescence from silicon vacancy centers in diamond p-i-n diodes. *Diamond and Related Materials,* Mai 2016, vol. 65, 42-46
- **M. BOSSERT.** Nachrichtenübertragung. Vieweg+Teubner Verlag, 04. August 2011
- **A. MERTINS.** Signaltheorie: Grundlagen der Signalbeschreibung, Filterbänke, Wavelets, Zeit-Frequenz-Analyse, Parameter- und Signalschätzung. Springer Vieweg, 08. Dezember 2012
- **LÜKE.** Signalübertragung: Grundlagen der digitalen und analogen Nachrichtenübertragungssysteme. Springer Vieweg, 19. Februar 2015